# EUROPÄISCHE PATENTSCHRIFT

(11) **EP 3 707 745 B1**
(45) Veröffentlichungstag und Bekanntmachung des Hinweises auf die Patenterteilung: **26.02.2025**
(21) Anmeldenummer: 18769367.6
(22) Anmeldetag: 14.09.2018
(51) Int. Cl.: H01L 21/302, B23K 26/53

(54) **VERFAHREN ZUM DÜNNEN VON MIT BAUTEILEN VERSEHENEN FESTKÖRPERSCHICHTEN, UND MEHRKOMPONENTEN-ANORDNUNG**
METHOD FOR THINNING SOLID-BODY LAYERS PROVIDED WITH COMPONENTS, AND ARRANGEMENT OF MULTIPLE COMPONENTS
PROCÉDÉ D'AMINCISSEMENT DE COUCHES DE SOLIDES POURVUES DE COMPOSANTS, ET ARRANGEMENT DE COMPOSANTS MULTIPLES

(30) Priorität: 07.11.2017 DE 102017010284
(43) Veröffentlichungstag der Anmeldung: 16.09.2020
(73) Patentinhaber: Siltectra GmbH, 01099 Dresden (DE)
(72) Erfinder: RIESKE, Ralf, 01099 Dresden (DE); SWOBODA, Marko, 01097 Dresden (DE); RICHTER, Jan, 01277 Dresden (DE)
(74) Vertreter: Westphal, Mussgnug & Partner, Patentanwälte mbB
(86) Internationale Anmeldenummer: PCT/EP2018/074893
(87) Internationale Veröffentlichungsnummer: WO 2019/091634

(56) Entgegenhaltungen:
- WO-A2-2016/083610
- DE-A1- 102013 007 672
- DE-A1- 102013 016 682
- DE-A1- 102015 006 971
- US-A1- 2009 242 010
- SAHA SAYAN ET AL: "Single heterojunction solar cells on exfoliated flexible PRG 25 m thick mono-crystalline silicon su", APPLIED PHYSICS LETTERS, A I P PUBLISHING LLC, US, vol. 102, no. 16, 22 April 2013 (2013-04-22), pages 163904 - 163904, XP012172701, ISSN: 0003-6951, [retrieved on 20130425], DOI: 10.1063/1.4803174

## Beschreibung

Die vorliegende Erfindung bezieht sich gemäß Anspruch 1 auf ein Verfahren zum Abtrennen von mindestens einer Festkörperschicht von mindestens einem Festkörper bzw. auf ein Verfahren zum Bereitstellen von mindestens einer Festkörperschicht und gemäß Anspruch 15 auf eine Mehrkomponentenanordnung (siehe DE 10 2014 014486 A1, die den Oberbegriff der Ansprüche 1 und 15 offenbart).

Eine Reihe von Bauelementen der Halbleiterindustrie werden auf gedünnten Festkörperschichten bzw. Substraten benötigt. Da dünne Substrate jedoch in den üblichen Prozessen schwer handhabbar sind und auch Wafer mit herkömmlichen Drahtsägeprozessen nur bis zu einer spezifischen Dicke hergestellt werden können, ist die häufigste Form der Herstellung von solchen Bauteilen auf dünnen Substraten das Wegschleifen oder Rückseitendünnen des Substrats nach fertiger Prozessierung.

Hierbei wird ein herkömmlicher Wafer zu Ende prozessiert, bevor in einem Schleif- und Polierschritt am Ende die finale gewünschte Substratstärke durch Entfernen des überschüssigen Materials hergestellt wird. Dieser Umstand ist aus zwei Gründen unvorteilhaft: zum einen geht zum Teil wertvolles Material im Schleifschritt verloren, zum anderen birgt der Schleif-/Polierschritt das Potenzial durch Beschädigung des Substrats das Potenzial für einen Totalverlust der bereits prozessierten Bauteile, die bereits einen Großteil der Wertschöpfung des Wafers enthalten.

Ein weiteres Verfahren zum Dünnen von Festkörpern wird durch die Druckschrift WO2014/177721A1 offenbart. Gemäß diesem Verfahren wird eine Polymerschicht auf einem Festkörper angebracht. Durch eine Temperierung der Polymerschicht werden dann Spannungen im Festkörper erzeugt, durch welche eine Festkörperschicht vom verbleibenden Festkörper abgetrennt wird.

In der Druckschrift DE 10 2012 001 620 A1 ist die Verwendung einer zusätzlichen Opferschicht zwischen Festkörper und Polymerfolie beschrieben, welche der verbesserten Entfernung der Polymerfolie nach dem Abspaltungsschritt dient, indem die Opferschicht beispielsweise chemisch durch Zugabe geeigneter Reaktanten zersetzt oder abgelöst wird. Nachteilig an diesem Verfahren ist jedoch die lange Zeitdauer, welche bis zu mehreren Stunden betragen kann, die bis zu einer vollständigen Entfernung der Polymerschicht vergeht. Dies schränkt eine industrielle Nutzung stark ein. Zur Beschleunigung des Prozesses der Polymerentfernung besteht die Möglichkeit, durch eine entsprechende Vorbehandlung zusätzliche Triebkräfte in Form von geeigneten, auch bei Raumtemperatur wirkenden Zugspannungen einzubringen. Diese führen zu einer Vergrößerung der Angriffsfläche für die Reaktanten oder das Lösungsmittel und begünstigen das Zersetzen oder das Ab- und Auflösen.

Weiterhin ist aus der WO 2010/072675 A2 bekannt, Füllstoffe im Polymer vorzusehen, um den thermischen Ausdehnungskoeffizienten oder den Elastizitätsmodul lokal beeinflussen zu können. Allerdings wurde festgestellt, dass derartige Füllstoffe oftmals die Haftung des Polymers auf der Oberfläche des zu teilenden Festkörpers verschlechtern, so dass keine ausreichende Kraftübertragung mehr möglich ist.

Die DE 10 2013 016 682 A1 betrifft ein Verfahren zum Herstellen von Festkörperschichten, wobei das Verfahren folgende Schritte umfasst: Bereitstellen eines Festkörpers zum Abtrennen mindestens einer Festkörperschicht; Erzeugen von Defekten mittels einer Strahlungsquelle, insbesondere einem Laser, in der inneren Struktur des Festkörpers zum Vorgeben einer Rissauslösestelle, ausgehend von der die Festkörperschicht vom Festkörper abgetrennt wird und/oder Erzeugen von Defekten mittels der Strahlungsquelle in der inneren Struktur des Festkörpers zum Vorgeben einer Rissführung, entlang der die Festkörperschicht vom Festkörper abgetrennt wird; Anordnen einer Aufnahmeschicht zum Halten der Festkörperschicht an dem Festkörper; thermisches Beaufschlagen der Aufnahmeschicht zum Erzeugen von Spannungen in dem Festkörper, wobei sich durch die Spannungen ein Riss ausgehend von der Rissauslösestelle und/oder entlang der Rissführung in dem Festkörper ausbreitet, wobei der Riss die Festkörperschicht von dem Festkörper abtrennt.

Die US 2009/0242010 A1 beschreibt ein Verfahren zum Abtrennen einer Halbleiterschicht von einem Wafer. Das Verfahren umfasst das Erzeugen einer Ablöseebene in dem Wafer, das Befestigen des Wafers an einem Aufnahmeelement und das Abtrennen der Halbleiterschicht von dem Wafer entlang der Ablöseebene. Das Erzeugen der Ablöseebene umfasst das Implantieren von Ionen in den Wafer.

Die DE 10 2015 006 971 A1 beschreibt ein Verfahren zum Abtrennen einer Halbleiterschicht von einem ersten Wafer. Das Verfahren umfasst das Befestigen des ersten Wafers an einem zweiten Wafer, das Erzeugen von Modifikationen in dem ersten Wafer durch Laserstrahlen, wodurch eine Rissebene definiert wird, und das Beaufschlagen des ersten Wafers mit mechanischer Spannung, um die Halbleiterschicht entlang der Abrissebene von dem ersten Wafer abzutrennen. Die Modifikationen in dem ersten Wafer können vor oder nach Befestigen des ersten Wafers an dem zweiten Wafer erzeugt werden.

Es ist also Aufgabe der vorliegenden Erfindung, das Dünnen von Halbleitersubstraten zu verbessern, insbesondere indem Material erhalten bleibt und die Waferverluste (der sog. Yield Loss) reduziert werden und/oder eine Möglichkeit zur vorteilhafteren Herstellung von elektrischen Komponenten bereitzustellen und/oder vorteilhafte Mehrkomponentenanordnungen bereitzustellen.

Die zuvor genannte Aufgabe wird gemäß Anspruch 1 durch ein Verfahren zum Bereitstellen von mindestens einer Festkörperschicht, wobei die Festkörperschicht von einem Festkörper abgetrennt wird, gelöst. Das erfindungsgemäße Verfahren umfasst dabei bevorzugt mindestens die Schritte: Erzeugung einer Vielzahl an Modifikationen mittels Laserstrahlen im Inneren des Festkörpers zum Ausbilden einer Ablöseebene, wobei durch die Modifikationen Druckspannungen im Festkörper erzeugt werden, Abtrennen der Festkörperschicht durch eine Separation des verbleibenden Festkörpers und der Festkörperschicht entlang der durch die Modifikationen ausgebildeten Ablöseebene, wobei zumindest Bestandteile der die Druckspannungen erzeugenden Modifikationen an der Festkörperschicht verbleiben, wobei so viele Modifikationen erzeugt werden, dass sich die Festkörperschicht aufgrund der Modifikationen vom Festkörper ablöst oder wobei eine äußere Kraft in den Festkörper zum Erzeugen von weiteren Spannungen in dem Festkörper eingeleitet wird, wobei die äußere Kraft so stark ist, dass die Spannungen eine Rissausbreitung entlang der durch die Modifikationen ausgebildeten Ablöseebene bewirken, Erzeugen einer Materialschicht, insbesondere einer Metallschicht, an der durch die Abtrennung der Festkörperschicht von dem Festkörper freigelegten Oberfläche zum zumindest teilweisen und bevorzugt mehrheitlichen und besonders bevorzugt vollständigen Kompensieren einer durch die Druckspannungen der verbleibenden Modifikationsbestandteile bewirkten Verformung der Festkörperschicht oder zum zumindest teilweisen und bevorzugt mehrheitlichen oder vollständigen Kompensieren der Druckspannungen.

Diese Lösung ist vorteilhaft, da sehr ebene Festkörperschichten bereitgestellt werden können, ohne dass eine spanende Bearbeitung der Festkörperschicht erfolgen muss. Dies ist insbesondere bei dem Festkörpermaterial SiC sinnvoll, da dessen Herstellung sehr teuer ist und daher Materialverluste möglichst zu vermeiden sind. Ferner ist SiC sehr hart, wodurch sehr teure Schleifwerkzeuge verwendet werden müssen, die aufgrund der hohen Härte von SiC sehr schnell verschleißen. Diese Lösung ist ferner sinnvoll da die bereitgestellten Festkörperschichten bereits mit einer Materialschicht, insbesondere einer Metallschicht, zur Ausbildung eines elektrischen Kontakts und/oder zur Ausbildung einer Schnittstelle zur Wärmeabfuhr ausgerüstet ist.

Die infolge der Abtrennung freigelegte Oberfläche der Festkörperschicht weist gemäß einer bevorzugten Ausführungsform der vorliegenden Erfindung erste Oberflächenanteile auf, die einen Ra-Wert (mittlere Rauheit) von weniger als 1, insbesondere von weniger als 0,9 oder von weniger als 0,7 oder von weniger als 0,5, insbesondere zwischen 0,01 und 0,4 aufweisen. Ferner weist die freigelegte Oberfläche der Festkörperschicht bevorzugt zweite Oberflächenanteile auf, die einen Ra-Wert (mittlere Rauheit) von mehr als 1, insbesondere zwischen 1 und 5, aufweisen. Der Anteil der ersten Oberflächenanteile ist dabei bevorzugt größer als der Anteil der zweiten Oberflächenanteile, wobei die zweiten Oberflächenanteile mindestens 1% oder mindestens 2% oder mindesten 5% oder mindestens 10% oder zwischen 1% und 49% oder zwischen 1% und 40% oder zwischen 1% und 30% oder zwischen 1% und 20% der aus den ersten Oberflächenanteilen und den zweiten Oberflächenanteilen gebildeten Gesamtfläche bilden. Diese Lösung ist vorteilhaft, da die Festkörperschicht selbst mit Anteilen die Ra-Werte zwischen 1 und 5 aufweisen, insbesondere ohne weitere Oberflächenkonditionierung, wie z.B. Schleifen oder Läppen, weiter verarbeitbar ist.

Die Materialschicht, insbesondere Metallschicht, wird gemäß einer weiteren bevorzugten Ausführungsform der vorliegenden Erfindung in einem ersten Aggregatzustand und einer Temperatur oberhalb der Raumtemperatur an der Festkörperschicht erzeugt und liegt bei Raumtemperatur in einem zweiten Aggregatzustand vor, wobei durch den Übergang vom ersten Aggregatzustand in den zweiten Aggregatzustand die Metallschicht die Festkörperschicht zum zumindest teilweisen Ausgleich und bevorzugt vollständigen Ausgleich der durch die Druckspannungen der verbleibenden Modifikationsbestandteile bewirkten Verformung bzw. der Druckspannungen beaufschlagt. Alternativ kann die Metallschicht in einem Temperaturbereich oberhalb der Raumtemperatur an der Festkörperschicht erzeugt werden, wobei der Temperaturbereich mindestens 100°C oder 150°C oder 200°C oder 250°C oder 300°C oder 350°C oder 400°C über der Raumtemperatur liegt und besonders bevorzugt bis maximal 2000°C oder kleiner als die Schmelz- oder Verdampfungstemperatur des Festkörpermaterials ist, wobei durch das Abkühlen der Metallschicht auf Raumtemperatur die Festkörperschicht zum zumindest teilweisen Ausgleich und bevorzugt vollständigen Ausgleich der durch die Druckspannungen der verbleibenden Modifikationsbestandteile bewirkten Verformung bzw. zum Ausgleich der Druckspannungen beaufschlagt. Es entstehen somit durch das Erkalten und/oder Verfestigen der Metallschicht Kräfte, insbesondere Zugkräfte, durch welche die Festkörperschicht bevorzugt negativ zu der durch die Druckspannungen bewirkten Verformung verformt wird oder durch welche die Druckspannungen kompensiert werden. Die Druckspannungen bewirken bevorzugt eine Verformung die als Bow bezeichnet wird. Als Raumtemperatur wird hierbei bevorzugt 20°C definiert, wobei die Raumtemperatur auch die Temperatur in einem Prozessraum beschreiben kann, welche bevorzugt zwischen 0°C und 100°C oder zwischen 20°C und 200°C liegen kann.

Die Metallschicht wird gemäß einer weiteren bevorzugten Ausführungsform der vorliegenden Erfindung durch Sputtern oder elektrochemisches Abscheiden erzeugt. Bevorzugt wird z.B. bei einer Modifikationsbestandteile aufweisenden SiC-Festkörperschicht bekannte Sputtermaterialien oder für das elektrochemische Abscheiden verwendbare Materialien, wie z.B. Titan, Titan-Wolfram, Nickel, Platin, TaSi₂ und/oder Gold verwendet werden. Die Dicke der Metallschicht bestimmt sich dabei bevorzugt durch die Parameter Dicke der Festkörperschicht, Material der Festkörperschicht, Fläche der Festkörperschicht, Anzahl und Art der Modifikationen.

Der Festkörper besteht gemäß einer weiteren bevorzugten Ausführungsform der vorliegenden Erfindung aus Siliziumcarbid (SiC) oder weist Siliziumcarbid (SiC) auf, wobei die Festkörperschicht bevorzugt mit einer Dicke von weniger als 200 µm, insbesondere mit einer Dicke von weniger als 150 µm oder von weniger als 125 µm oder von weniger als 110 µm oder von weniger als 100 µm oder von weniger als 90 µm oder von weniger als 75 µm, vom Festkörper abgetrennt wird. Diese Lösung ist vorteilhaft, da SiC mittels den hier vorgeschlagenen Verfahren sehr gut beherrschbar ist und somit mit deutlich geringerem Materialverlust und mit deutlich geringeren Verschleiß der Behandlungseinrichtungen elektrische Komponenten erzeugbar sind.

Die elektrischen Komponenten sind gemäß einer weiteren bevorzugten Ausführungsform der vorliegenden Erfindung vertikale Bauelemente, insbesondere Schottky Dioden und/oder Metall-Oxid-Halbleiter-Feldeffekttransistor (MOSFETs), wobei die Metallschicht einen elektrischen Kontakt, insbesondere einen ohmschen Kontakt, ausbildet und/oder eine Schnittstelle zur Wärmeabfuhr ausbildet. Diese Ausführungsform ist vorteilhaft, da vertikale Bauelemente durch die vorliegende Erfindung bei vergleichsweise geringen Material- und Verschleißverlusten sehr flach (z.B. durch die Verwendung von SiC) und somit auch leichter erzeugt werden können. Dies schafft die Möglichkeit, dass deutlich energieeffizientere und preisgünstiger elektrische Bauteile erzeugt werden.

Die elektrischen Komponenten sind gemäß einer weiteren bevorzugten Ausführungsform der vorliegenden Erfindung horizontale Bauelemente, insbesondere high-electron-mobility transistors (HEMT), wobei die die Metallschicht bevorzugt eine Schnittstelle zur Wärmeabfuhr ausbildet. Diese Ausführungsform ist vorteilhaft, da diese Bauteile kleiner, leichter und günstiger hergestellt werden können.

Gemäß einer weiteren bevorzugten Ausführungsform der vorliegenden Erfindung werden im Durchschnitt pro cm2 einer ebenen Oberflächenseite der Festkörperschicht eine Vielzahl, insbesondere mindestens 4 oder mindestens 9 oder mindestens 36 oder mindestens 100, an elektrischen Komponenten erzeugt, wobei die elektrischen Komponenten nach ihrer Erzeugung mittels Dicing voneinander getrennt werden. Diese Ausführungsform ist vorteilhaft, da die einzelnen elektrischen Komponenten schnell und sehr schonend voneinander abtrennbar sind. Bevorzugt weisen die einzelnen elektrischen Komponenten rechteckige, insbesondere quadratischen, Grundflächen auf. Die elektrischen Komponenten weisen bevorzugt Außenkanten zwischen 0,1mm und 5mm auf.

Bevorzugt erfolgt somit, insbesondere vor einem Prozessieren der Bauelemente, die Erzeugung einer Lasermodifizierungsschicht in dem Festkörper bzw. Substrat, die die spätere Dünnebene bzw. die Ablöseebene definiert. Besonders bevorzugt finden erst danach die weiteren Prozesse zum Aufbauen bzw. Erzeugen von Schichten und/oder zur Bauteilherstellung statt (Lithographie, etc.).

Die zusammen mit der Festkörperschicht die Kompositstruktur ausbildenden Schichten und/oder Bauteile werden bevorzugt mittels Lithographie, insbesondere Beschichten mit z.B. Metallverbindungen, Belacken, optischer Belichtung (z.B. Scannen durch eine Photomaske), Entwickeln des Photolacks (insbesondere bei niedrigen Temperaturen, wie Temperaturen unter 70°C, insbesondere unter 50°C oder unter 30°C oder unter Umgebungstemperatur oder unter 20°C oder unter 5°C oder unter 0°C), Ätzen von Strukturen, bewirkt. Zum Erzeugen einer Schaltung, insbesondere einer fertigen Schaltung, können einzelne oder mehrere oder alle dieser Prozesse, insbesondere Lithografieprozesse, mehrfach insbesondere mehr als 10 mal oder bis zu 10 mal oder mehr als 20 mal oder bis zu 20 mal oder mehr als 40 mal oder bis zu 40 mal oder mehr als 80 mal oder bis zu 80 mal wiederholt werden.

Der nach dem Abtrennen der Festkörperschicht verbleibende Festkörper weist bevorzugt eine Dicke auf, die größer, insbesondere um ein Vielfaches größer, ist als die Dicke der abgetrennten Festkörperschicht. Das Festkörpermaterial ist bevorzugt ein Halbleitermaterial oder weist ein Halbleitermaterial auf.

Es ist hierbei zu verstehen, dass "an oder über" einer Oberfläche der abzutrennenden Festkörperschicht auch derart verstanden werden kann, dass im Fall eines der Laserbehandlung zur Erzeugung der Modifikationen vorgelagerten Hochtemperaturschrittes eine Beschichtung der durch das Hochtemperaturverfahren erzeugten Oberfläche erfolgen kann, an der dann die weitere Schicht bzw. weiteren Schichten und/oder Bauteile zum Erzeugen der Kompositstruktur angeordnet oder erzeugt werden. Die Kompositstruktur wird definitionsgemäß erst nach der Laserbehandlung erzeugt, ein eventuell vor der Laserbehandlung vorliegende mehrschichtige Anordnung wird im Rahmen dieser Patentanmeldung nicht als Kompositstruktur benannt, sondern als mehrschichtige Anordnung.

Dünnen bedeutet hierbei die Reduzierung der Dicke des Festkörpers, der bevorzugt ein Wafer ist, um den Materialanteil, der bei gewöhnlichen Herstellverfahren von mit Bauteilen versehenen Festkörpern, insbesondere Wafern, abrasiv entfernt, also z.B. abgefräst, geschliffen oder wegpoliert werden würde.

Weitere bevorzugte Ausführungsformen sind Gegenstand der Unteransprüche und der nachfolgend angeführten Beschreibungsteile.

Gemäß einer bevorzugten Ausführungsform der vorliegenden Erfindung wird zum Einleiten der äußeren Kraft eine Aufnahmeschicht an einer freiliegenden Oberfläche der Kompositstruktur angeordnet, wobei die Aufnahmeschicht ein Polymermaterial aufweist und die Aufnahmeschicht zum, insbesondere mechanischen, Erzeugen von Spannungen in dem Festkörper thermisch beaufschlagt wird, wobei die thermische Beaufschlagung ein Abkühlen der Aufnahmeschicht auf eine Temperatur unterhalb der Umgebungstemperatur darstellt, wobei die Abkühlung derart erfolgt, dass das Polymermaterial der Aufnahmeschicht eine partielle oder vollständige Kristallisation und / oder einen Glasübergang vollzieht und wobei sich durch die Spannungen ein Riss in dem Festkörper entlang der Ablöseebene ausbreitet, der die erste Festkörperschicht von dem Festkörper abtrennt oder die äußere Kraft wird durch eine Beaufschlagung des Festkörpers mit Ultraschall in den Festkörper eingeleitet, wobei der Festkörper hierbei bevorzugt in einem mit einer Flüssigkeit befüllten Behälter angeordnet ist. Der Ultraschall kann mit einem Frequenzbereich von 20 kHz bis 100 kHz aber auch im Hochfrequenzschallbereich mit einem Frequenzbereich von 100 kHz bis 1 MHz zum Einsatz kommen. Aufgrund dieser Frequenzen kommt es bevorzugt an Festkörpern in flüssigen Medien zu Kavitationsvorgängen mit Folgeerscheinungen wie zum Beispiel kollabierenden Kavitationsblasen. In flüssigen Medien besonders im Bereich von Phasengrenzen kommt es im Nanosekundenbereich zu Implosion und Deformation von sich dynamisch bildenden Kavitationsblasen und der Ausbildung eines Microjets. Die ortsaufgelöste Energieabgabe geschieht in Form einer adiabatischen Erwärmung auf sehr kleinem Raum durch die sehr schnelle Kompression des Gases. Hierbei treten extreme Temperaturen von bis zu 5000 Kelvin und Drücke bis zu 500 bar auf, die neue sonst nicht stattfindende physikalische Reaktionen im Bereich der Grenzschicht ermöglichen. Diese enormen Druckunterschiede resultieren aus dem Rückstoß der Blasenfront nach außen (implodierende Schockwelle). Hierbei kommt es zu stark erhöhten Reaktionsgeschwindigkeiten in diesem Bereich. Erfindungsgemäß wird besonders bevorzugt eine ortsaufgelöste CNC gesteuerte Beaufschlagung mit Hilfe einer Ultraschallspitze (Sonotrode) die gezielt eine Beeinflussung der Rissauslösung und/oder Rissführung herbeiführen kann. Die ortsaufgelöste Druckbeaufschlagung kann gezielt zur Rissauslösung und/oder Rissführung genutzt werden.

Die homogene und / oder ortsaufgelöste Ausführungsform ist vorteilhaft, da insbesondere bei Verwendung der Aufnahmeschicht eine sehr präzise Krafteinleitung und somit Rissauslösung und/oder Rissführung bewirkt werden kann.

Der Festkörper wird gemäß einer weiteren bevorzugten Ausführungsform der vorliegenden Erfindung vor der Erzeugung der Ablöseebene mit mindestens einem Hochtemperaturverfahren behandelt, wobei das Hochtemperaturverfahren mit einer Temperatur zwischen 70°C und der Schmelztemperatur oder Verdampfungstemperatur des Materials des Festkörpers ausgeführt wird.

Somit stellt die Durchführung des Laserschritts an einem teilprozessierten Wafer eine weitere Möglichkeit dar, dies wird erfindungsgemäß besonders bevorzugt nach den Hochtemperaturschritten, aber vor den übrigen Prozessen durchgeführt. Diese Lösung ist vorteilhaft, da noch nicht alle Strukturen ausgebildet sind, die durch das Laserverfahren geschädigt werden können.

Hierbei können Parameter des Laserverfahrens derart optimiert werden, dass der Stress im Festkörper möglichst minimiert wird, z.B. durch schonendes mehrfaches Beaufschlagen des Festkörpers, durch größere Linienabstände und kleiner werdende Energien bei jeder Überfahrt.

Der Laserprozess wird bevorzugt in Abhängigkeit der kristallographischen Orientierung des Substrats durchgeführt, d.h. die Lasermodifikation wird besonders bevorzugt möglichst so geführt, dass im Zuge der Behandlung entstehende Mikrorisse weder die Lithographie behindern noch überkritisch aus der Modifikationsebene herauslaufen und zum Substratverlust nach dem Auslösen des Abtrennrisses führen können. Hierbei können z.B. in SiC erste Linien parallel zur bevorzugten Rissrichtung geführt werden, um eine Rissebene zu definieren, bevor in einem zweiten Schritt Linien in 90° Richtung dazu die Risse final auslösen und die Trennebene definieren.

Die Durchführung der Hochtemperaturschritte vor der Erzeugung der Ablöseebene ist höchst vorteilhaft, da eine deutliche Erhöhung der Temperatur über 70 °C mit einer erhöhten Mobilität von Dotieratomen, Atomen metallischer Verschmutzungen und Versetzungen oder anderen Kristallbaufehlern einhergeht. Wäre nun die Ablöseebene vor dem Hochtemperaturschritt erzeugt worden oder teilweise erzeugt worden, dann könnten z.B. dadurch entstandene Mikrorisse sich weiter in den Festkörper oder in die abzutrennende Festkörperschicht hinein erstrecken bzw. hineinwachsen, wodurch mehr Material abgetragen werden müsste und somit größere Verluste auftreten würden.

Das mindestens eine Hochtemperaturverfahren ist gemäß einer weiteren bevorzugten Ausführungsform der vorliegenden Erfindung ein Epitaxieverfahren, ein Dotierverfahren oder ein Verfahren, in dem Plasma eingesetzt wird. Als Hochtemperaturverfahren werden alle Verfahren, insbesondere materialablagernde Verfahren, verstanden, die bei einer Temperatur oberhalb von 70°C ausgeführt werden. Die auftretende Temperatur ist bevorzugt kleiner als 2000°C oder kleiner als die Schmelz- oder Verdampfungstemperatur des Festkörpermaterials. Durch das Hochtemperaturverfahren wird bevorzugt eine mehrschichtige Anordnung aus Festkörpermaterial und der einen oder mindestens einen erzeugten bzw. angeordneten Schicht geschaffen.

Durch das Hochtemperaturverfahren wird gemäß einer weiteren bevorzugten Ausführungsform der vorliegenden Erfindung mindestens eine Schicht auf dem Festkörper erzeugt, wobei die mindestens eine erzeugte Schicht vordefinierte Parameter aufweist, wobei zumindest ein vordefinierter Parameter einen maximalen Grad an Brechung und/oder Absorption und/oder Reflexion und/oder Ladungsträgergeneration durch Photoeffekt von Laserlichtwellen vorgibt, wobei der Grad an Brechung und/oder Absorption und/oder Reflexion und/oder Ladungsträgergeneration durch Photoeffekt unter 5% und bevorzugt unter 1% und besonders bevorzugt unter 0,1% liegt. Diese Ausführungsform ist vorteilhaft, da Wechselwirkungen aller metallischen Elemente der Schaltung mit Laserlicht unterbunden werden. Infolge von Wechselwirkungen zwischen einer Metallschicht oder metallischen Bauteilen und Laserlicht bzw. Laserstrahlung kann die Metallschicht und/oder die Bauteile, insbesondere elektrische Leitungsverbindungen, beschädigt werden.

Ferner wird durch diese Ausführungsform das weitere Problem gelöst, dass beim Einbringen der Laserebene, wenn bereits metallische Strukturen oder Bauteile (z.B. größer 20nm Längsausdehnung bzw. Erstreckung in Lasereindringrichtung) auf dem Substrat angeordnet oder erzeugt sind, wobei der Laserprozess entweder durch Rückreflexe an den Strukturen oder durch die Strukturen selbst gestört wird, da z.B. die Transmission nicht ideal ist. Da bevorzugt zum Erzeugen der Materialmodifikationen ein Multiphotonenprozess genutzt wird, muss der Fokus im Material bevorzugt sehr genau, insbesondere ideal, sein um die benötigten hohen Intensitäten bei gleichzeitig möglichst ungestörten Wellenfronten zu ermöglichen. Somit spricht auch dieser Vorteil für eine Laserbehandlung vor der Prozessierung bzw. Erzeugung der finalen Strukturen, insbesondere Schichten und/oder Bauteile.

Die Modifikationen werden gemäß einer weiteren bevorzugten Ausführungsform der vorliegenden Erfindung bevorzugt mittels einer Mehrphotonenanregung, insbesondere einer Zweiphotonenanregung, erzeugt.

Bevorzugt wird zunächst eine Vielzahl an Basis-Modifikationen auf einer zumindest abschnittsweise homogen verlaufenden, insbesondere gekrümmten, Linie, insbesondere in dem homogen verlaufenden Abschnitt, erzeugt. Diese Basis-Modifikationen werden bevorzugt mit bzw. in Abhängigkeit von vordefinierten Prozessparametern erzeugt. Die vordefinierten Prozessparameter umfassen bevorzugt zumindest die Pulsdauer, Pulsenergie, Pulsabstand innerhalb einer Linie, Abstand der Linien zueinander, Tiefe und/oder numerische Apertur. Bevorzugt wird zumindest ein Wert dieser Prozessparameter und bevorzugt mehrere Werte oder alle Werte dieser Prozessparameter oder mehr als zwei Werte dieser Prozessparameter in Abhängigkeit von der Kristallgitterstabilität des Festkörpers festgelegt. Der Wert so ist dabei besonders bevorzugt so gewählt, dass das Kristallgitter um die jeweiligen Basis-Modifikationen herum intakt bleibt, d.h. bevorzugt weniger als 20µm oder weniger als 10µm oder weniger als 5µm oder weniger als 1µm einreißt.

Gemäß einer weiteren bevorzugten Ausführungsform der vorliegenden Erfindung werden Auslösemodifikation zum Auslösen von unterkritischen Rissen erzeugt, wobei zumindest ein Prozessparameter zum Erzeugen der Auslösemodifikationen von zumindest einem Prozessparameter zum Erzeugten der Basis-Modifikationen verschieden ist, bevorzugt sind mehrere Prozessparameter voneinander verschieden. Zusätzlich oder alternativ können die Auslösemodifikationen in einer Richtung erzeugt werden, die zur Verlaufsrichtung der Linie, entlang der die Basis-Modifikationen erzeugt werden, geneigt oder beabstandet ist, wobei sich die unterkritischen Risse bevorzugt weniger als 5mm, insbesondere weniger als 4mm oder weniger als 3mm oder weniger als 2mm oder weniger als 1mm oder weniger als 0,5mm, ausbreiten. Eine geneigte Ausrichtung kann hierbei z.B. einem Winkel zwischen 0° und 90° entsprechen, bevorzugt einem Winkel zwischen 85° und 90° und besonders bevorzugt einen Winkel von 90°.

Es handelt sich um einen Schwellprozess, der ausgelöst wird, wenn eine kritische Intensität (also Leistung/Fläche) überschritten wird. Das heißt, kurze Pulse brauchen weniger Energie/Puls, höhere numerische Apertur konzentriert die Energie auf einen kleineren Punkt, braucht also auch niedrigere Energie um die Schwellintensität zu erreichen.

Eine größere Tiefe bedeutet meist Absorptionsverluste, weswegen die Energie dahingehend wieder angepasst werden muss, Beispiel SiC: NA=0.4, 180µm Tiefe, 3ns Pulslänge, Pulsenergie ca. 7µJ, bei 350µm Tiefe eher 9µJ.

Generell brauchen härtere Materialien (Saphir, Aluminiumoxidkeramik, SiC, GaN) in den Linien größeren Pulsüberlapp, also kleinere Pulsabstände (<=1µm), dafür werden die Linienabstände tendenziell größer gewählt (z.B. >5µm), während weichere Materialien wie GaAs und Si eher größere Pulsabstände (>1µm) und dafür kleinere Linienabstände (<5µm) benötigen.

Beispielmuster SiC - mit fs-Pulsen: Pulsenergie ca. 800nJ, Pulsabstand 50nm und größer, bis 200nm, Linienmuster wie folgt: 30 Linien mit 1µm Abstand, dann 20µm Lücke, dann wieder 30 Linien, dann 96µm Lücke und dann von vorn, gekreuzt mit 30 Linien, 20µm Lücke und 30 Linien (immer mit 1µm Abstand zwischen den Linien), dann 300µm Lücke und dann wieder 30/20/30-er Linienblock. Tiefe 180µm, Dotiergrad des SiC (durch Flächenwiderstand charakterisiert >21mOhm cm), Pulslänge 400fs, numerische Apertur 0.65.

Das Festkörpermaterial ist gemäß einer bevorzugten Ausführungsform Silizium, wobei die Numerische Apertur zwischen 0,5 und 0,8, insbesondere bei 0,65, liegt, die Einstrahltiefe zwischen 150µm und 1500µm, insbesondere bei 300µm, liegt der Pulsabstand zwischen 1µm und 5µm, insbesondere bei 2µm, liegt, der Linienabstand zwischen 1µm und 5µm, insbesondere bei 2 µm, liegt, die Pulsdauer zwischen 50ns und 400ns, insbesondere bei 300ns, liegt und die Pulsenergie zwischen 3µJ und 30µJ, insbesondere bei 10µJ, liegt.

Das Festkörpermaterial ist gemäß einer bevorzugten Ausführungsform SiC, wobei die Numerische Apertur zwischen 0,4 und 0,8, insbesondere bei 0,4, liegt, die Einstrahltiefe zwischen 50µm und 500µm, insbesondere bei 180µm, liegt der Pulsabstand zwischen 0,1µm und 3µm, insbesondere bei 1µm, liegt, der Linienabstand zwischen 10µm und 100µm, insbesondere bei 75 µm, liegt, die Pulsdauer zwischen 100fs und 10ns, insbesondere bei 3ns, liegt und die Pulsenergie zwischen 0,5µJ und 30µJ, insbesondere bei 7µJ, liegt.

Beispielmuster Aluminiumoxidkeramik: Pulsabstand 500nm, Linienabstand 10µm, Pulsdauer 3ns, Pulsenergie 22µJ, NA=0.4
Beispielmuster Saphir: 3fach geschriebene Linien in 0°, 45°, 90°, jeweils mit 1,5µm Linienabstand, Pulsabstand 300nm, Pulsenergie im ersten Durchgang 350nJ, im zweiten Durchgang 300nJ und im dritten Durchgang 250nJ, bei einer NA von 0.65 und einer Pulsdauer von 250fs.

Generell nimmt die Oberflächenrauhigkeit mit kürzeren Pulsen ab, mit Femtosekundenpulsen kann man bessere Oberflächen erzeugen (Rauheiten unter 3µm) als mit Nanosekundenpulsen (eher über 3µm), dafür ist der Prozess teurer und dauert länger. Pikosekundenpulse stellen einen Mittelweg dar. Der Vorteil bei kürzeren Pulsen ist, dass die Phasenumwandlung athermischer erfolgt, also Kopplung zwischen Laserpuls und Kristallgitter erfolgt, damit weniger Schwingungen (Phononen) angeregt werden - der Prozess also insgesamt kälter abläuft. Dafür müssen größere Bereiche amorphisiert (Phasenumwandlung) werden, damit die kritische Spannung aufgebaut wird, die die Risse auslöst.

Gemäß einer weiteren bevorzugten Ausführungsform der vorliegenden Erfindung breiten sich die unterkritischen Risse zwischen 5µm und 200µm, insbesondere zwischen 10µm und 100µm oder zwischen 10µm und 50µm oder zwischen 10µm und 30µm oder zwischen 20µm und 100µm oder zwischen 20µm und 50µm oder zwischen 20µm und 30µm, im Festkörper aus. Diese Ausführungsform ist vorteilhaft, da eine kleinere Rissausbreitung geringere Nachbearbeitungsaufwendung erfordert. Die unterkritischen Risse breiten sich entlang der Kristallgittergrenzen aus, da das Kristallgitter des Festkörpers jedoch bevorzugt gegenüber der Ablöseebene, insbesondere in einem Winkel zwischen 0°und 6°, geneigt ist, resultiert eine im Profil sägezahnförmige Oberfläche. Je weiter die Risse laufen, desto größer ist der Abstand zwischen den Tälern und Spitzen dieser sägezahnförmigen Oberfläche, wodurch auch umso mehr Material entfernt werden muss, wenn eine Oberflächenrauheit von weniger als 80nm oder von weniger als 50nm oder zwischen 20nm und 50nm erzeugt werden soll.

Die Rissausbreitung der unterkritischen Risse verläuft somit gemäß einer weiteren Ausführungsform der vorliegenden Erfindung gegenüber der Einstrahlrichtung der Laserstrahlen in einer von einem Winkel von 90° abweichenden geneigten Richtung, insbesondere ist die Rissausbreitungsrichtung bevorzugt zwischen 93° und 95°, insbesondere genau 94°, gegenüber der Einstrahlrichtung geneigt.

Gemäß einer weiteren bevorzugten Ausführungsform der vorliegenden Erfindung reißen die Abschnitte zwischen den Bereichen mehrerer Linien, in denen sich die unterkritischen Risse ausgebreitet haben, infolge der Spannungen bzw. der Einleitung der äußeren Kraft, die z.B. durch den Glasübergang oder die Ultraschallbehandlung erzeugt werden, ein. Diese Ausführungsform ist vorteilhaft, da aufgrund der zuvor bewirkten Vorschädigungen im Inneren des Festkörpers, insbesondere aufgrund der unterkritischen Risse, die erforderlichen Spannungen deutlich geringer sein können. Ferner wird der Riss sehr präzise geführt.

Die Aufnahmeschicht wird gemäß einer weiteren bevorzugten Ausführungsform der vorliegenden Erfindung an einer Oberfläche des Festkörpers angeordnet oder daran erzeugt, die gegenüber der Oberfläche des Festkörpers liegt, an der die Schichten und/oder Bauteile zum Ausbilden der Kompositstruktur angeordnet sind.

Vor dem Auslösen des Risses wird auf der Seite des Festkörpers, an der bevorzugt keine weitere Schicht und/oder Bauelemente angeordnet sind, die verfahrensgemäße Aufnahmeschicht, insbesondere in Form einer Polymerfolie, aufgebracht.

Die Aufnahmeschicht gemäß einer weiteren bevorzugten Ausführungsform der vorliegenden Erfindung massemäßig zumindest mehrheitlich und bevorzugt vollständig aus dem Polymermaterial besteht, wobei der Glasübergang des Polymermaterials zwischen -130°C und 0°C, insbesondere zwischen -85°C und -10°C oder zwischen -80°C und -20°C oder zwischen -65°C und -40°C oder zwischen -60°C und -50°C, liegt.

Gemäß einer weiteren bevorzugten Ausführungsform der vorliegenden Erfindung besteht das Polymermaterial der Aufnahmeschicht aus einem Polymer-Hybrid-Material bzw. weist ein solches auf, das eine Polymermatrix ausbildet, wobei sich in der Polymermatrix ein Füllstoff befindet, wobei die Polymermatrix bevorzugt eine Polydimethylsiloxan-Matrix ist und wobei der Masseanteil der Polymermatrix am Polymer-Hybrid-Material bevorzugt 80 % bis 99 % und besonders bevorzugt 90 % bis 99 % beträgt.

Erfindungsgemäß wird daher ein Polymer-Hybrid-Material zur Verwendung in einem Splitting-Verfahren angegeben, bei welchem aus einem Festkörper-Ausgangsmaterial zumindest zwei Festkörper-Teilstücke erzeugt werden. Das erfindungsgemäße Polymer-Hybrid-Material umfasst eine Polymermatrix und zumindest einen darin eingebetteten ersten Füllstoff. Insofern im Folgenden von einem bzw. dem Füllstoff die Rede ist, soll gleichfalls die Möglichkeit mehrerer Füllstoffe mit einbezogen sein. Beispielsweise kann der Füllstoff eine Mischung verschiedener Materialien umfassen, z. B. Metalloxide, Metallpartikel und anorganische Fasern.

Als Polymermatrix kann jedes Polymer oder eine Mischung verschiedener Polymere genutzt werden, mit dessen Hilfe sich die für eine Teilung des Festkörper-Ausgangsmaterials notwendigen Spannungen erzeugen lassen. Beispielsweise kann die Polymermatrix als Elastomermatrix, bevorzugt als Polydiorganolsiloxan-Matrix, besonders bevorzugt als Polydimethylsiloxan-Matrix, ausgebildet sein. Derartige Polymermaterialien lassen sich besonders einfach als Matrixmaterial in Kombination mit Füllstoffen nutzen, da die Eigenschaften aufgrund des variierbaren Vernetzungsgrads flexibel eingestellt und an den jeweiligen Füllstoff sowie das zu teilende Festkörper-Ausgangsmaterial angepasst werden können. Gemäß einer Ausführungsvariante beträgt der Masseanteil der Polymermatrix am Polymer-Hybrid-Material 80 % bis 99 %, 10 bevorzugt 90 % bis 99 %.

Der erste Füllstoff kann organischer oder anorganischer Natur sein und sowohl aus einem chemischen Element als auch aus einer chemischen Verbindung oder einem Stoffgemisch, beispielsweise einer Legierung, bestehen.

Der erste Füllstoff ist derart aufgebaut, dass er als Reaktant, Initiator, Katalysator oder Promotor während des Ablösens des Polymer-Hybrid-Materials vom Festkörper- Teilstück nach der Teilung wirkt und dadurch im Vergleich zu einem Polymermaterial ohne ersten Füllstoff zu einem schnelleren Ablösen des Polymer-Hybrid-Materials vom Festkörper-Teilstück nach der Teilung führt.

Die konkrete chemische Zusammensetzung und Ausgestaltung des ersten Füllstoffs sowie dessen Masseanteil ist dabei insbesondere abhängig vom konkreten Material der Polymermatrix, welche abgelöst werden soll, dem dafür genutzten Lösungsmittel und den verwendeten Reaktanten. Weiterhin spielen auch das Material des Festkörper-Ausgangsmaterials und die Dimensionen des zu teilenden Festkörper-Ausgangsmaterials eine Rolle.

Der konkrete Anteil des ersten Füllstoffs in der Polymermatrix ist stark vom Material des Füllstoffs und dessen Wirkungsweise abhängig. Zum einen muss die Polymermatrix trotz Füllstoff ihrer Aufgabe der Erzeugung von Spannungen noch gerecht werden können. Zum anderen muss der Anteil des ersten Füllstoffs hoch genug sein, um die angestrebte Beeinflussung der Polymerentfernung zu erreichen. Den jeweils optimalen Masseanteil des ersten Füllstoffs kann der Fachmann im Rahmen einfacher konzentrationsabhängig durchgeführter Versuche ermitteln.

Zur Verbesserung der mechanischen Eigenschaften kann zusätzlich ein weiterer Füllstoff, wie z. B. pyrogene Kieselsäure in Form eines anorganischen Netzwerkes im Polymer beitragen. Neben diesen starken Wechselwirkungen in Form des Netzwerks können auch weniger starke Interaktionen durch rein hydrodynamische Verstärkungen zur Verbesserung beitragen. Beispielhaft ist hier eine gezielte Steigerung der Viskosität zu nennen, die eine verbesserte Verarbeitung im Splitting-Verfahren ermöglicht und so zu verbesserten Fertigungstoleranzen beitragen kann. Weiterhin wird durch diese Wechselwirkung eine Verringerung der inneren
Freiheitsgrade hinsichtlich einer strukturellen Umorientierung mit zunehmender Bewehrung erschwert.

Dies führt zu einer gewünschten Erniedrigung der Glasübergangstemperatur des eingesetzten Polymers im Polymer-Hybrid-Material, was den Vorteil einer geringeren Temperatur im Splitting-Verfahren ermöglicht. Erfindungsgemäß wird der erste Füllstoff in einem Polymer-Hybrid-Material zur Beschleunigung des Ablösens des Polymer-Hybrid-Materials von einem Festkörper-Teilstück, das durch Teilung mittels eines Splittingverfahrens, bei dem ein Festkörper-Ausgangsmaterial in zumindest zwei Festkörper-Teilstücke geteilt wird, erhalten wird, verwendet.

Der erste Füllstoff kann in der Polymermatrix derart verteilt sein, dass der Masseanteil des ersten Füllstoffs ausgehend von der äußeren, d. h. unteren, Grenzfläche des Polymer-Hybrid-Materials, die während des Splitting-Verfahrens mit dem Festkörper-Ausgangsmaterial verbunden ist, in Richtung einer parallel zur unteren Grenzfläche angeordneten weiteren Grenzfläche des Polymer-Hybrid- Materials, abnimmt. Dies bedeutet, dass der Masseanteil des Füllstoffs nahe beim Festkörper-Ausgangsmaterial bzw. Teilstück größer ist als in den übrigen Bereichen des Polymer-Hybrid-Materials. Diese Verteilung des ersten Füllstoffs ermöglicht eine besonders effektive Entfernung des Polymer-Hybrid-Materials nach der Trennung, da sich der erste Füllstoff nahe an der Grenzfläche zum Festkörper-Teilstück befindet und dort seine Wirkung entfalten kann. Geleichzeitig weisen die restlichen Bereiche des Polymer-Hybrid-Materials weniger oder gar keine Anteile des ersten Füllstoffs auf, so dass die Funktion des Polymers möglichst wenig beeinflusst wird.

In einer Ausgestaltung ist das Polymer-Hybrid-Material schichtförmig aufgebaut, wobei lediglich eine dem Festkörper-Ausgangsmaterial zugewandte Schicht den ersten Füllstoff aufweist, während das restliche Polymer-Hybrid-Material frei vom ersten Füllstoff ist.

Weiterhin kann ein unterer Bereich des Polymer-Hybrid-Materials, der direkt an dessen untere Grenzfläche angrenzt frei von dem ersten Füllstoff sein. Damit kann sich eine Bereichsabfolge wie folgt ergeben: Benachbart zum Festkörper-Ausgangsmaterial befindet sich zunächst ein Bereich ohne ersten Füllstoff, darauf folgt ein Bereich mit einem hohen Anteil an erstem Füllstoff und danach ein Bereich mit niedrigem Anteil an erstem Füllstoff oder ohne ersten Füllstoff.

Diese und alle im Folgenden beschriebenen Bereiche können in Form von Schichten ausgebildet sein, d. h. der Bereich erstreckt sich überwiegend parallel zu der Grenzfläche des Festkörper-Ausgangsmaterials, auf die das Polymer-Hybrid-Material aufgebracht wird und weist eine Längs- und Querausdehnung zumindest im Bereich dieser Grenzfläche auf.

Ein unterer Bereich ohne ersten Füllstoff kann insbesondere für den Fall vorgesehen werden, dass der erste Füllstoff die Haftung des Polymer-Hybrid-Materials auf dem Festkörper-Ausgangsmaterial verschlechtert. Um dies zu vermeiden, wird zunächst ein Bereich ohne ersten Füllstoff angeordnet, auf den ein Bereich mit einem hohen Anteil an erstem Füllstoff folgt, damit der erste Füllstoff seine Funktion erfüllen kann. Eine untere Schicht ohne ersten Füllstoff kann beispielsweise eine Dicke zwischen 10 µm und 500 µm, beispielsweise 100 µm, aufweisen.

Weiterhin kann ein oberer Bereich des Polymer-Hybrid-Materials, der direkt an dessen obere Grenzfläche angrenzt frei von dem ersten Füllstoff sein. Unter der oberen Grenzfläche ist dabei die Grenzfläche zu verstehen, die das Polymer-Hybrid-Material gegenüberliegend zur unteren Grenzfläche und zum Festkörper-Ausgangsmaterial zur Umgebung hin begrenzt. Untere und obere Grenzfläche können parallel zueinander angeordnet sein.

Ein solcher oberer Bereich ohne ersten Füllstoff kann insbesondere dann vorgesehen werden, wenn der erste Füllstoff die Wärmeübertragung zwischen Umgebung und Polymer-Hybrid-Material nachteilig beeinflusst, beispielsweise wenn die Abkühlung des Polymer-Hybrid-Materials verzögert werden würde.

Der erste Füllstoff kann ein Material umfassen oder aus einem Material bestehen, dass mit einem Reaktionsmittel, bevorzugt einem Oxidationsmittel unter Freisetzung eines gasförmigen Produkts reagieren kann.

Dadurch sind in der Polymermatrix Kavitäten generierbar, die einen schnelleren Zugang der Reaktanten und Lösungsmittel zur Polymermatrix und einer etwaige vorhandenen Opferschicht ermöglichen und zudem einen schnelleren Abtransport der Edukte und gelösten Bestandteile bewirken.

Durch die Generierung gasförmiger Reaktionsprodukte können zusätzliche Triebkräfte eingebracht werden, die die Entfernung des Polymer-Hybrid-Materials weiter unterstützen.

Die Ausbildung zusätzlicher Kavitäten sowie das Entstehen gasförmiger Reaktionsprodukte beschleunigt die Polymerentfernung und trägt daher zu einer Erhöhung der Gesamtausbeute des Splitting-Verfahrens bei. Durch Variation des Anteils an erstem Füllstoff kann die Kavitätendichte im Grenzbereich zwischen Festkörper-Teilstück und Polymer-Hybrid-Material bzw. zwischen Opferschicht und Polymer- Hybrid-Material gezielt beeinflusst werden.

Der erste Füllstoff kann ein Metall, insbesondere Aluminium, Eisen, Zink und/oder Kupfer umfassen oder aus einem Metall, insbesondere den zuvor genannten Metallen, bestehen.

"Bestehend aus" schließt auf alle vorliegend genannten Materialien bezogen ein, dass technologisch bedingte Verunreinigungen oder technologisch bedingte Beimengungen, die z. B. der Herstellung der Füllstoffe sowie deren Verteilung oder Anbindung an die Polymermatrix dienlich sind, enthalten sein können.

Metallische Füllstoffe können mit Oxidationsmitteln wie z.B. Salzsäure, Salpetersäure, Zitronensäure, Ameisensäure oder Sulfaminsäure reagieren unter Freisetzung eines gasförmigen Produkts reagieren und dadurch aus dem Polymer-Hybrid-Material entfernt werden.

Beispielsweise reagiert Aluminium mit konzentrierter Salzsäure unter Ausbildung von solvatisierten Metallionen und Wasserstoff gemäß folgender Gleichung:

6 HCl + 2 Al + 12 H₂O → 2 [AlCl₃*6 H2O] + 3 H₂

In ähnlicher Weise führt die Reaktion von Zink als Füllstoff durch Reaktion mit konzentrierter Salzsäure zur Bildung 5 zusätzlicher Kavitäten: Zn + 2 HCl → ZnCl₂ + H₂ In den genannten Beispielen werden durch die Generierung von Wasserstoff, zusätzliche Triebkräfte eingebracht, die die Entfernung des Polymer-Hybrid-Materials weiter unterstützen. Zudem kann der erste Füllstoff die Temperaturleitfähigkeit innerhalb des Polymer-Hybrid-Materials verbessern, beispielsweise, indem der erste Füllstoff eine höhere Temperaturleitfähigkeit als das Polymer der Polymermatrix aufweist. Dies kann beispielsweise der Fall sein, wenn Ein weiterer Vorteil für den Fall, dass der erste Füllstoff ein Metall umfasst, liegt in der verbesserten Temperaturleitfähigkeit innerhalb des Polymer-Hybrid- Materials. Dadurch Durch eine verbesserte Temperaturleitfähigkeit sind können die für die Teilung des Festkörper-Ausgangsmaterials mittels Abkühlung erzeugten Spannungen effektiver, d. h. schneller und unter geringerem Verbrauch an Kühlmittel, generierbar sein. Dies erhöht kann die Gesamtausbeute des Splitting-Verfahrens erhöhen.

Weiterhin kann im Polymer-Hybrid-Material ein zweiter 25 Füllstoff vorgesehen sein, der die Haftung des Polymer- Hybrid-Materials auf dem Festkörper-Ausgangsmaterial im Vergleich zu einem Polymer-Hybrid-Material ohne zweiten Füllstoff erhöht. Bevorzugt wird die Haftung im Vergleich zu einem Polymermaterial ohne Füllstoff erhöht.

Beispielsweise kann es sich bei dem zweiten Füllstoff um einen Füllstoff handeln, der mittels Plasma aktiviert werden kann. Durch die Plasmaaktivierung resultieren neue Oberflächenspezies, die so geschaffen werden können, dass eine stärkere Wechselwirkung mit der Oberfläche des Festkörper-Ausgangsmaterials resultiert und im Ergebnis die Haftung des Polymer-Hybrid-Materials verbessert wird.

Die Art der durch die Plasmabehandlung erzielbaren Oberflächenspezies ist dabei vorrangig von der Prozessführung des Plasmaprozesses abhängig. Beispielsweise können während der Plasmabehandlung Gase wie Stickstoff, Sauerstoff, Silane oder Chlorsilane zugefügt werden, so dass beispielsweise polare Gruppen entstehen, welche stärker mit der Oberfläche des Festkörper- Ausgangsmaterials wechselwirken können.

Der zweite Füllstoff kann in der Polymermatrix so verteilt 15 sein, dass der Masseanteil des zweiten Füllstoffs in Richtung der unteren Grenzfläche zunimmt. Beispielsweise kann das Polymer-Hybrid-Material den zweiten Füllstoff lediglich in einem Bereich angrenzend an die untere Grenzfläche enthalten, wobei der Bereich auch als Schicht im Sinne der oben genannten Definition ausgebildet sein kann.

Dies ermöglicht die Anordnung des zweiten Füllstoffs bevorzugt in der Nähe der Grenzfläche zwischen Polymer-Hybrid-Material und Festkörper-Ausgangsmaterial, wodurch die Haftung verbessert und damit eine größere Kraftübertragung in das zu teilende Festkörper-Ausgangsmaterial ermöglicht wird. Beispielsweise kann der zweite Füllstoff Kern-Schale-Polymerpartikel bzw. Core-Shell-Polymerpartikel umfassen.

Dabei sind Partikel bevorzugt, deren Polymerzusammensetzung sich von der Polymermatrix des Polymer-Hybrid-Materials dahingehend unterscheidet, dass insbesondere die Oberfläche, d. h. die Schale, der Kern-Schale-Partikel stärker aktivierbar ist, z. B. mittels Niedertemperaturplasmas.

Beispiele hierfür sind Kern-Schale-Partikel umfassend einen Polysiloxan-Kern mit einer Acrylat-Schale oder umfassend einen nanoskaligen Silikat-Kern mit einer Epoxid-Schale oder umfassend einen Kautschukpartikel-Kern mit eines Epoxid-Schale oder umfassend einen Nitrilkautschukpartikel-Kern mit einer Epoxid-Schale. Der zweite Füllstoff kann mittels Niedertemperaturplasma, z.B. Kaltplasma, aktivierbar sein. Beispielsweise kann das Plasma mittels dielektrischer Barriereentladung (DBE) erzeugt werden. Hierbei können Elektronendichten im Bereich von 1014 bis 1016 m-3 erzeugt werden. Die durchschnittliche Temperatur des durch DBE erzeugten "kalten" Nichtgleichgewichtsplasmas (Plasmavolumen) beträgt ca. 300 ± 40 K bei Umgebungsdruck. Die durchschnittliche Temperatur des durch DBE erzeugten nichtthermischen Plasmas beträgt ca. 70 °C bei Umgebungsdruck.

Bei der DBE-Behandlung wird die Oberfläche beispielsweise mit uni- oder bipolaren Pulsen von Pulsdauern von wenigen Mikrosekunden bis zu einigen zehn Nanosekunden und Amplituden im einstelligen bis zweistelligen Kilovoltbereich beaufschlagt. Hierbei sind keine metallischen Elektroden im Entladungsraum und somit keine metallischen Verunreinigungen oder Elektrodenverschleiß zu erwarten.

Vorteilhaft ist zudem eine hohe Effizienz, da an den Elektroden keine Ladungsträger aus- oder eintreten müssen.

Dielektrische Oberflächen können bei niedrigen Temperaturen modifiziert und chemisch aktiviert werden. Die Oberflächenmodifikation kann beispielsweise durch eine Wechselwirkung und Reaktion der Oberflächenspezies durch lonenbombardement erfolgen.

Weiterhin können gezielt Prozessgase, wie z. B. Stickstoff, Sauerstoff, Wasserstoff, Silane oder Chlorsilane, z. B. SiₓH_{y}E_{z} mit E=F,Cl,Br,I,O,H und x=0 bis 10, z=0 bis 10, SiH₄, Si(EtO)₄ oder Me₃SiOSiMe₃, bei einer Plasmabehandlung zugefügt werden, um beispielsweise bestimmte chemische Gruppen an der Oberfläche zu erzeugen. Der zweite Füllstoff kann des Weiteren mittels Korona- 5 Behandlung, Flammenbehandlung, Fluorierung, Ozonierung oder UV-Behandlung bzw. Eximer-Bestrahlung aktivierbar sein. Durch eine derartige Aktivierung werden beispielsweise polare Gruppen an der Oberfläche des zweiten Füllstoffs generiert, die mit der Oberfläche des Festkörper-Ausgangsmaterials wechselwirken können und so die Haftung verbessern. Das Polymer-Hybrid-Material kann weiterhin zusätzlich im Vergleich zu einem Polymer-Hybrid-Material mit einem ersten oder zu einem Polymer-Hybrid-Material mit einem ersten und einem zweiten Füllstoff einen dritten Füllstoff umfassen. Dieser dritte Füllstoff weist im Vergleich zu dem Polymer der Polymermatrix eine höhere Temperaturleitfähigkeit und/oder einen höheren Elastizitätsmodul auf.

Beispielsweise liegt der E-Modul des Polymers bei Tieftemperaturbedingungen im unteren einstelligen Gigapascalbereich (ca. 1-3 GPa), während beispielsweise metallische Füllstoffe einen E-Modul im zweistelligen bis dreistelligen Gigapascalbereich aufweisen. Bei einem entsprechenden hohen Füllstoffanteil ist ein perkolierendes Füllstoffnetzwerk möglich, was eine verbesserte "Krafteinkopplung" in das Festkörper-Ausgangsmaterial ermöglicht.

Die Perkolation wird wesentlich durch den Volumenfüllgrad der jeweiligen Füllstoffe beeinflusst (z. B. 0,1 Vol%, 1 30 Vol% bis 10 Vol% je nach Aspektverhältnis). Mit zunehmender Krafteinleitung kann der viskoelastische Schichtaufbau der Polymerstruktur eingetaucht werden und mehrere Perkolationspfade wirksam werden. Hier können verbesserte Wärmeübergänge ermöglicht werden, da es zu einem verbesserten Kontakt der Füllstoffe mit der Oberfläche des Festkörper-Ausgangsmaterials kommen kann.

Die mechanische Stabilität des Polymer-Hybrid-Materials wird auch bei tiefen Temperaturen schneller erreicht. In Summe kommt es zu einer geringeren Standardabweichung der entsprechenden Struktur-Eigenschaftsprofile wie z. B. Bruchspannung und Bruchdehnung des Polymer-Hybrid-Materials und somit zu einer Erhöhung der Gesamtausbeute des Splitting-Verfahrens. Die ortsaufgelösten Eigenschaftsprofiländerungen (Spannungsspitzen im Polymer-Hybrid- Material) und somit im Festkörper sind kleiner, was zu einer höheren Gesamtausbeute des Splitting-Verfahrens und einer besseren Qualität der erzeugten Festkörper-Teilstücke führt.

Der dritte Füllstoff kann einen verbesserten Wärmeübergang zwischen Umgebung und Polymer-Hybrid-Material und eine schnellere Wärmeleitung innerhalb des Polymer-Hybrid-Materials bewirken, sodass das Polymer-Hybrid-Material schneller abgekühlt werden kann und das Splitting-Verfahren insgesamt schneller und damit effektiver durchgeführt werden kann.

Durch eine Erhöhung des Elastizitätsmoduls lassen sich höhere Spannungen für die Teilung des Festkörper-Ausgangsmaterials erzeugen, so dass auch Festkörper-Ausgangsmaterialien geteilt werden können, für die eine besonders hohe Spannung benötigt wird.

Zudem kann der dritte Füllstoff auch der Beeinflussung des thermischen Ausdehnungskoeffizienten dienen. Ziel ist dabei ein möglichst großer Unterschied zwischen den Wärmeausdehnungskoeffizienten des Polymer-Hybrid-Materials und des zu teilenden Festkörper-Ausgangsmaterials, um zusätzliche, für die Teilung notwendige Spannungen erzeugen zu können. Bevorzugt weist der dritte Füllstoff einen hohen thermischen Ausdehnungskoeffizienten, d. h. einen Ausdehnungskoeffizienten, der höher als derjenige der Polymermatrix ist, auf. Beispielsweise kann der thermische Ausdehnungskoeffizient des dritten Füllstoffs mehr als 300 ppm/K betragen.

Der dritte Füllstoff kann so in der Polymermatrix verteilt sein, dass der Masseanteil des dritten Füllstoffs in Richtung der oberen Grenzfläche zunimmt, um einen schnelleren Wärmeübergang insbesondere an der Grenzfläche zur Umgebung zu ermöglichen.

Der dritte Füllstoff kann ein Metall, insbesondere Aluminium, Eisen, Zink und/oder Kupfer, umfassen oder aus einem der genannten Metalle bestehen. Metalle zeichnen sich im Allgemeinen durch eine hohe Wärmeleitfähigkeit und Temperaturleitfähigkeit aus.

Die beschriebenen Füllstoffe (erster, zweiter, dritter Füllstoff) können in partikulärer Form in der Polymermatrix verteilt vorliegen, wobei die Partikelgröße im µm- und nm-Bereich, bezogen auf zumindest eine Dimension des Partikels, liegen kann. Neben einer kugelförmigen Gestalt können die Füllstoffpartikel auch andere Ausgestaltungen, beispielsweise eine stäbchenförmige oder scheibenförmige Gestalt annehmen.

Die Füllstoffpartikel können sämtliche Partikelgrößenverteilungen aufweisen, beispielsweise monomodal oder bimodal, eng, insbesondere monodispers, oder breit. Die Füllstoffe können an die Polymermatrix sowohl physikalisch, z. B. durch Einbettung in das Polymernetzwerk, als auch chemisch angebunden sein. Weiterhin können einer oder mehrere der beschriebenen, Füllstoffe anorganische oder organische Fasern, beispielsweise Kohle-, Glas-, Basalt- oder Aramidfasern, umfassen oder aus solchen bestehen, sofern die zuvor beschriebenen Funktionen damit vereinbar sind. Optional kann auch ein weiterer Füllstoff hinzugefügt werden, der die genannten Fasern umfasst oder aus solchen besteht.

Fasern weisen üblicherweise stark anisotrope Eigenschaften auf. Durch eine richtungsabhängige Positionierung des Füllstoffs im Polymer-Hybrid-Material besteht die Möglichkeit einer gezielten Beeinflussung der für die Teilung des Festkörper-Ausgangsmaterials notwendigen Spannungen. Dies kann zur Erhöhung der Gesamtausbeute des Splitting-Verfahrens beitragen. Ein zusätzlicher Vorteil besteht in dem Falle, dass ein organischer oder anorganischer Füllstoff als Faserstoff mit einer stark anisotropen Struktur eingesetzt wird, darin, dass dadurch eine Verbesserung der mechanischen Eigenschaften innerhalb des Polymer-Hybrid-Materials erreicht werden kann.

Die beschriebenen Füllstoffe können zudem Kern-Schale- Partikeln umfassen oder daraus bestehen. Zusätzlich oder alternativ kann ein weiterer Füllstoff umfassend oder bestehend aus Kern-Schale-Partikeln im Polymer-Hybrid- Material vorgesehen sein.

Der Einsatz von Kern-Schale-Polymerpartikeln erlaubt zusätzlich neben einer verbesserten Aktivierbarkeit auch eine neue Gestaltung von energieabsorbierenden Mechanismen, die in Summe zu einer Schlagzähigkeits- und Bruchzähigkeitserhöhung, insbesondere einer Erhöhung der Tieftemperatur-Schlagzähigkeit, des Polymer-Hybrid-Materials beim Einsatz im Splitting-Verfahren führen können und somit ebenfalls zu einer höheren Gesamtausbeute des Splitting- Verfahrens beitragen können. Beispielsweise kann eine mechanische Zerstörung einer Folie aus einem Polymer-Hybrid-Material mit einer geringeren Wahrscheinlichkeit auftreten, so dass die Möglichkeit einer Wiederverwendung der Folie begünstigt werden kann.

Beispielhaft kann durch Unterbindung der Rissausbreitung aufgrund von Kern-Schale-Polymerpartikel eine Zerstörung der Folie beim Splitting-Verfahren verhindert werden und somit Wiederverwertungswege eröffnet werden.

Hierbei können enthaltene Elastomerpartikel eine plastische Deformation erfahren und Hohlräume bilden, wodurch weitere zusätzliche Energie aufgenommen werden kann. Ebenso ist eine zusätzliche Energieaufnahme durch das Scherfließen der Matrix kompensierbar, was insgesamt die mechanischen Eigenschaften verbessert. Kern-Schale-Partikel zeichnen sich dadurch aus, dass ein in der Regel kugelförmiger Kern aus einem Material von einer Schale aus einem zweiten Material umgeben ist. Die Schale kann entweder den Kern komplett umhüllen oder aber auch durchlässig sein. Bei den Materialien kann es sich sowohl um anorganische Materialien, wie z. B. Metalle, oder um organische Materialien, wie z. B. Polymere handeln. Beispielsweise können zwei verschiedene Metalle miteinander kombiniert werden. Es besteht aber auch die Möglichkeit, einen Kern aus einem Polymer mit einer Schale aus einem Metall oder einem zweiten Polymer zu umgeben.

Kern-Schale-Partikel ermöglichen die Kombination der Eigenschaften des ersten und zweiten Materials. Beispielsweise kann über einen preiswerten Polymerkern die Größe und Dichte der Füllstoffpartikel festgelegt werden, während die metallische Schale wie oben beschrieben reagieren kann. Aufgrund ihrer oftmals monodispersen Partikelgrößenverteilung lassen sich die Eigenschaften der Kern-Schale-Partikel zudem präzise vorhersagen und einstellen.

Darüber hinaus können ein oder mehrere Füllstoffe (erster, 5 zweiter und/oder dritter Füllstoff) Kohlenstoff in Form von Industrieruß (Carbon Black), Graphit, zerkleinerten Kohlenstofffasern (chopped carbon fiber), Kohlenstoffnanofasern (carbon nanofibers), bevorzugt in Form von Kohlenstoffnanoröhrchen (carbon nanotubes, CNT), wie z.B. mehrwandigen Kohlenstoffnanoröhrchen (multi-walled carbon nanotubes, MWCNT) sowie einwandigen Kohlenstoffnanoröhrchen (single-walled carbon nanotubes, SWCNT), umfassen oder aus diesen bestehen. Bei Kohlenstoffnanoröhrchen handelt es sich um zylinderförmige Graphitlagen, die aus einer unterschiedlichen Anzahl an Zylindern aufgebaut sind.

Bestehen diese Röhrchen nur aus einem Zylinder, so werden sie als singlewalled carbon nanotubes (SWCNT) bezeichnet. Sind zwei oder mehr Zylinder vorhanden, entstehen entweder double-walled (DWCNT) oder die multi-walled carbon nanotubes (MWCNT). Diese können vorzugsweise konzentrisch ineinander geschachtelt vorliegen.

Gemäß verschiedenen Ausführungsvarianten kann der dritte Füllstoff MWCNTs umfassen oder aus diesen bestehen, da diese eine besonders hohe Wärmeleitfähigkeit (> 3000 W*(m*K)⁻¹) besitzen und gleichzeitig eine sehr hohe Reißfestigkeit im Bereich von 5-60 GPa aufweisen. Die hohe mechanische Stabilität zeigt sich dabei in hohen Reißwerten, extremer Elastizität und einer sehr guten Strapazierfähigkeit des Füllstoffs.

Grundlage hierfür sind die sp2 hybridisierten starken σ-C-C- Bindungen verbunden mit einem delokalisierten p-Orbital als π-Bindung zu drei benachbarten Kohlenstoffatomen. Hierbei sind Verbiegungen bis zu 90° möglich.

Mit SWCNT sind noch höhere Eigenschaftswerte erreichbar (E- Modul: 410 GPa bis 4150 GPa vs. Graphit: 1000 GPa, SWCNT: Wärmeleitfähigkeit ca. 6000 W*(m*K)⁻¹). Allerdings zeigt sich hier ein schlechteres Leistungs-/Kosten-Verhältnis im Vergleich zu MWCNT. Die Zylinderdurchmesser von MWCNT liegen typischerweise im Bereich von 1 nm bis 100 nm, bevorzugt von 5 bis 50 nm, mit einer Länge von 500 nm bis 1000 µm.

Gemäß weiteren Ausführungsvarianten kann der dritte Füllstoff MWCNT umfassen und gleichzeitig der zweite und/oder erste Füllstoff Industrieruß umfassen oder aus diesem bestehen, da hier ebenfalls eine Verbesserung der Wärmeleitfähigkeit (z. B. bis zu 200 W*(m*K)⁻¹) erreicht werden kann. Da der Einsatz von beispielhaft Industrieruß eine deutlich geringere Reißfestigkeit mit Werten von < 0,4 GPa aufweist, ist eine Kombination aus beiden oder weiteren Füllstoffen möglich und kann zu einer Verbesserung der Gesamtsplitausbeute und zu einer Verbesserung der Gesamtkosten im Splitting-Verfahren führt.

20 Hierbei liegen die mittleren Durchmesser der Rußpartikel (Carbon Black) im Bereich von 5 nm bis 500 nm, bevorzugt von 20 nm bis 200 nm, besonders bevorzugt von 40 nm bis 100 nm.

Weiterhin können die Füllstoffe Kieselsäure, beispielsweise pyrogene Kieselsäure, umfassen oder aus dieser bestehen. 25 Zusätzlich oder alternativ kann ein weiterer Füllstoff umfassend oder bestehend aus Kieselsäure im Polymer-Hybrid-Material vorgesehen sein.

Pyrogene Kieselsäure kann ein dreidimensionales Netzwerk ausbilden und dadurch zur Verbesserung der mechanischen 30 Stabilität beitragen. Somit kann ein solcher Füllstoff der gezielten Einstellung der mechanischen Eigenschaften des Polymer-Hybrid-Materials dienen. Einer oder mehrere der genannten Füllstoffe (erster, zweiter, dritter Füllstoff) können aus demselben Material bestehen, sofern dies mit der ihnen zugeschriebenen Funktion vereinbar ist. Beispielsweise kann sowohl der erste als auch der dritte Füllstoff Aluminium umfassen oder aus Aluminium bestehen. Aluminium lässt sich wie oben beschrieben sowohl zur Generierung von Kavitäten und damit zur Beschleunigung des Ablösens des Polymer-Hybrid-Materials vom Festkörper- Teilstück nutzen als auch zur Erhöhung der Temperaturleitfähigkeit. Eine derartige Ausgestaltung vereinfacht den Herstellungsprozess, da es ausreichend sein kann, nur einen oder zwei Füllstoffe hinzuzufügen, um alle Funktionen zu erfüllen.

Erster und zweiter sowie ggf. dritter Füllstoff können auch aus unterschiedlichen Materialien bestehen. Dadurch wird eine individuelle und damit bessere Anpassung des Füllstoffs an die gewünschte Funktion ermöglicht.

Eine erfindungsgemäße Folie umfasst ein Polymer-Hybrid-Material, wie obenstehend beschrieben. Die Folie kann eine Dicke von beispielsweise 0,5 bis 5 mm aufweisen.

Auf zumindest diese Oberfläche wird ein erfindungsgemäßes Polymer-Hybrid-Material oder eine erfindungsgemäße Folie aufgebracht, so dass eine entsprechende Verbundstruktur resultiert. Das aufgebrachte Polymer-Hybrid-Material bzw. die aufgebrachte Folie werden im Folgenden auch als Aufnahmeschicht bezeichnet. Die Dicke einer solchen Aufnahmeschicht kann beispielsweise zwischen 0,5 mm und 5 mm, insbesondere zwischen 1mm und 3mm, liegen. Optional kann das Polymer-Hybrid-Material oder die Folie auch auf mehrere freiliegende Oberflächen, insbesondere auf parallel zueinander angeordnete Oberflächen aufgebracht werden.

Die thermische Beaufschlagung stellt bevorzugt ein Abkühlen der Aufnahmeschicht unter die Umgebungstemperatur und bevorzugt unter 10 °C und besondere bevorzugt unter 0 °C und weiter bevorzugt unter -10 °C oder unter -40 °C dar.

Die Abkühlung der Aufnahmeschicht erfolgt höchst bevorzugt derart, dass zumindest ein Teil der Aufnahmeschicht einen Glasübergang vollzieht oder aber eine partielle oder vollständige Kristallisation durchläuft. Die Abkühlung kann hierbei eine Abkühlung auf unter -130 °C sein, die z. B. mittels flüssigen Stickstoffs bewirkbar ist. Diese Ausführungsform ist vorteilhaft, da sich die Aufnahmeschicht in Abhängigkeit von der Temperaturveränderung zusammenzieht und/oder einen Glasübergang erfährt und die dabei entstehenden Kräfte auf das Festkörper-Ausgangsmaterial übertragen werden, wodurch mechanische Spannungen in dem Festkörper erzeugbar sind, die zum Auslösen eines Risses und/oder zur Rissausbreitung führen, wobei sich der Riss zunächst entlang der ersten Ablöseebene zum Abspalten der Festkörperschicht ausbreitet.

In einem weiteren Schritt wird das Polymer-Hybrid-Material oder die Folie vom Festkörper-Teilstück, beispielsweise durch eine chemische Reaktion, ein physikalischer Ablösevorgang und/oder mechanisches Abtragen, entfernt.

Der Ablösevorgang des Polymer-Hybrid-Materials vom Festkörper-Teilstück kann bei moderater Umgebungstemperatur, z. B. im Bereich von 20 °C bis 30 °C stattfinden, bevorzugt im höheren Temperaturbereich von 30 °C bis 95 °C, z. B. von 50 °C bis 90 °C, oder aber beispielsweise auch in einem unteren Temperaturbereich zwischen 1 °C und 19 °C.

Der erhöhte Temperaturbereich kann eine Verkürzung einer chemischen Ablösereaktion aufgrund einer Erhöhung der Reaktionsgeschwindigkeit ermöglichen, z. B. im Falle der Verwendung einer Opferschicht zwischen dem Polymer-Hybrid-Material und dem Festkörper. Im Falle der Verwendung einer Opferschicht kann das Ablösen in wässriger Lösung erfolgen, vorteilhaft bei einem pH-Wert im Bereich von 2 - 6. Gemäß verschiedenen Ausführungsvarianten kann beispielhaft der Ablösevorgang in Form einer Behandlung mit einer Lösung aus einem geeigneten apolaren Lösungsmittel erfolgen, wobei moderate Umgebungstemperaturen im Bereich von 1 °C bis 50 °C bevorzugt und von 20°C bis 40°C besonders bevorzugt sind.

Ein besonderer Vorteil hierbei ist das Ablösen ohne eine Temperatureinwirkung auf die Folie. Hierbei können vorteilhaft aliphatische und aromatische Kohlenwasserstoffe wie z. B. Toluol, n-Pentan, n-Hexan, aber auch halogenierte Lösungsmittel, wie z. B. Tetrachlorkohlenstoff, angewendet werden. Hierbei können zusätzliche Kräfte in das abzulösende Polymer-Hybrid-Material und die Grenzfläche zum Festkörper-Teilstück eingebracht werden, da durch eine Lösungsmittelbehandlung eine sehr starke reversible Quellung des Polymers-Hybriden-Materials auftreten kann, wodurch das Ablösen insgesamt vereinfacht wird.

Gemäß weiteren Ausführungsvarianten kann eine Kombination mit dem oben beschriebenen Ablösemechanismus der Opferschicht und der Behandlung mit einem geeigneten apolaren Lösungsmittel erfolgen - ebenfalls ohne Temperatureinwirkung auf die Folie.

An der freiliegenden Schicht oder den freiliegenden Bauteilen der erzeugten Kompositstruktur kann eine Stabilisierungsschicht zum Begrenzen von Verformungen der freiliegenden Schicht oder der freiliegenden Bauteile angeordnet oder erzeugt werden, wobei die Verformungen aus den mittels der Aufnahmeschicht eingeleiteten mechanischen Spannungen resultieren. Die Seite mit Bauteilen wird somit bevorzugt geschützt und gehalten (z.B. gegen Verwölbung des Substrats bzw. des Festkörpers und Grauraumbedingungen). Dies kann über lösliche Polymere (Organik) oder Halteschichten geschehen. Diese Ausführungsform ist vorteilhaft, da dadurch Wechselwirkung mit z.B. kleinen Memsstrukturen begrenzt werden. Die Oberflächenbeschaffenheit eines mit Bauteilen ausgeführten Wafers ist in gewöhnlich nicht regelmäßig, was bei zu starken oder abrupten Bewegungen zu Feldüberhöhungen und lokalen Oberflächenschäden führen kann. Somit stellt diese Ausführungsform eine Lösung dar, die einen guten Schutz der Festkörperschicht und der daran angeordneten und/oder erzeugten Schichten und/oder Bauteilen, insbesondere gegen mechanische Beschädigung oder Zerstörung, bewirkt.

Das Verfahren kann bevorzugt ebenfalls oder alternativ einzelne oder mehrere der Schritte umfassen: Bereitstellen eines Festkörpers zum Abtrennen mindestens einer Festkörperschicht, wobei der Festkörper einen ersten ebenen Flächenanteil und einen zweiten ebenen Flächenanteil aufweist, wobei der erste ebene Flächenanteil bevorzugt im Wesentlichen oder genau parallel zu dem zweiten ebenen Flächenanteil ausgerichtet ist.

Erzeugen von Defekten mittels mindestens einer Strahlungsquelle, insbesondere einem Laser, in der inneren Struktur des Festkörpers zum Vorgeben einer Rissauslösestelle, ausgehend von der die Festkörperschicht vom Festkörper abgetrennt wird.

Erzeugen von Defekten oder Modifikationen mittels Laserstrahlen mindestens eines Lasers in der inneren Struktur des Festkörpers zum Vorgeben einer Rissführung, entlang der die Festkörperschicht vom Festkörper abgetrennt wird, wobei die Laserstrahlen über den zweiten ebenen Flächenanteil in den Festkörper eindringen,
Gemäß einer weiteren bevorzugten Ausführungsform der vorliegenden Erfindung besteht die Stabilisierungsschicht aus bzw. weist auf eine bevorzugt wasserlösliche Keramik, insbesondere Fortafix von Detakta, und/oder ein lösliches Polymer, insbesondere Poly(ethylenglycol) (PEG), insbesondere mit unterschiedlichen und/oder angepassten Kettenlängen. Bei Fortafix handelt es sich um Ein- und Zweikomponenten-Keramikzemente zum Einsatz als Kleber, Glasur zum Schutz vor Korrosion und chemischen Einflüssen, Gießmasse für den Formenbau oder zur Isolation, als Tauchmasse zur Befestigung von Heizdrähten, für das Einsetzen von Messerklingen, z.B. in Metall oder Keramikgriffen. Das Polymer (PEG) ist in Wasser und einer Reihe von organischen Lösemitteln löslich. Es ist unlöslich in Hexan, Diethylether und tert-Butylmethylether - also anderen organischen Lösungsmitteln. Dementsprechend können die Oberflächenstrukturen/Bauteile mit PEG verfüllt werden, bevor eine Schutzschicht aufgebracht wird. Die Stabilisierungsschicht wird bevorzugt in-situ erzeugt oder als Folie bereitgestellt. Zusätzlich oder alternativ wird die Stabilisierungsschicht eingegossen bzw. die Schicht und/oder die freiliegenden Bauteile werden mit flüssigem Material beaufschlagt, das erst durch Aushärten bzw. Verfestigen zur Stabilisierungsschicht wird. Die Stabilisierungsschicht wird zusätzlich oder alternativ durch Aufbringen eines Lösungsmittels oder durch Eintauchen in ein Lösungsmittel von der Schicht oder den freiliegenden Bauteilen entfernt. Die Stabilisierungsschicht weist somit ein Keramikmaterial auf oder besteht daraus und/oder sie weist ein Polymermaterial auf oder besteht daraus.

Gemäß einer weiteren bevorzugten Ausführungsform der vorliegenden Erfindung werden die Modifikationen nacheinander in mindestens einer Zeile oder Reihe oder Linie erzeugt, wobei die in einer Zeile oder Reihe oder Linie erzeugten Modifikationen bevorzugt in einem Abstand X und mit einer Höhe H erzeugt werden, damit ein sich zwischen zwei aufeinander folgenden Modifikationen ausbreitender Riss, insbesondere in Kristallgitterrichtung ausbreitender Riss, dessen Rissausbreitungsrichtung in einem Winkel W gegenüber der Ablöseebene ausgerichtet ist, die beiden Modifikationen miteinander verbindet. Der Winkel W liegt hierbei bevorzugt zwischen 0° und 6°, insbesondere bei 4°. Bevorzugt breitet sich der Riss von einem Bereich unterhalb des Zentrums einer ersten Modifikation hin zu einem Bereich oberhalb des Zentrums einer zweiten Modifikation hin aus. Der hierbei wesentliche Zusammenhang ist daher, dass die Größe der Modifikation in Abhängigkeit des Abstands der Modifikationen und des Winkels W verändert werden kann bzw. muss.

Gemäß einer weiteren bevorzugten Ausführungsform der vorliegenden Erfindung werden in einem ersten Schritt die Modifikationen auf einer Linie und bevorzugt im gleichen Abstand zueinander erzeugt. Weiterhin ist vorstellbar dass eine Vielzahl dieser im ersten Schritt erzeugten Linien erzeugt werden. Diese ersten Linien werden besonders bevorzugt parallel zur Rissausbreitungsrichtung uns bevorzugt geradlinig oder kreisbogenförmig, insbesondere in derselben Ebene, erzeugt. Nach der Erzeugung dieser ersten Linien werden bevorzugt zweite Linien zum Auslösen und/oder Treiben von bevorzugt unterkritischen Rissen erzeugt. Diese zweiten Linien werden ebenfalls bevorzugt geradlinig erzeugt. Besonders bevorzugt sind die zweiten Linien gegenüber den ersten Linien geneigt, insbesondere orthogonal ausgerichtet. Die zweiten Linien erstrecken sich bevorzugt in derselben Ebene wie die ersten Linien oder besonders bevorzugt in einer Ebene die parallel zu der Ebene ist, in der sich die ersten Linien erstrecken. Anschließende werden bevorzugt dritte Linien erzeugt zum Verbinden der unterkritischen Risse erzeugt.

Gemäß einer weiteren bevorzugten Ausführungsform der vorliegenden Erfindung ist eine Kühleinrichtung zum Abkühlen der Aufnahmeschicht auf eine Temperatur zwischen -130°C und -10°C, insbesondere auf eine Temperatur zwischen -80°C und -50°C, vorgesehen. Die Kühleinrichtung weist bevorzugt ein Vernebelungsmittel, insbesondere mindestens oder genau eine perforierte Rohrleitung, zum Vernebeln von flüssigem Stickstoff auf und die Kühlwirkung wird besonders bevorzugt durch vernebelten Stickstoff erzeugt. Alternativ ist denkbar, dass die Kühleinrichtung ein Stickstoffbad aufweist, wobei die Aufnahmeschicht beabstandet zu in dem Stickstoffbad vorgehaltenen flüssigen Stickstoff positioniert wird. Alternativ ist denkbar, dass die Kühleinrichtung ein, insbesondere flüssigen oder nebelartigen, Stickstoff bevorzugt gleichförmig bereitstellendes Sprühmittel vorgesehen ist, wobei das Sprühmittel bevorzugt oberhalb und/oder seitlich der Aufnahmeschicht angeordnet ist. Diese Ausführungsform ist vorteilhaft, da der flüssige Stickstoff zum definierten Abkühlen von Objekten sehr gut geeignet ist. Ferner ist diese Ausführungsform vorteilhaft, da gegenüber Tieftemperaturprozessen von weniger als -80°C oder von weniger als -90°C ein sehr viel energieeffizienterer Prozess bereitgestellt wird.

Die Kühleinrichtung weist bevorzugt ein Stickstoffbad und eine Positioniereinrichtung um definierten Einstellen des Abstands der Position der Aufnahmeschicht zu den im Stickstoffbad vorgehaltenen flüssigen Stickstoff auf, wobei das Stickstoffbad und die Positioniereinrichtung bevorzugt in einem gegenüber der Umgebung zumindest teilweise und bevorzugt vollständig abgegrenzten Raum angeordnet sind.

Eine oder mehrere Temperaturmesseinrichtung/en ist/sind gemäß einer weiteren bevorzugten Ausführungsform der vorliegenden Erfindung vorgesehen. Bevorzugt werden mit den Temperaturmessvorrichtung/en und Temperaturmessung/en durchgeführt, wobei die erfassten Temperaturwerte bevorzugt zur Regelung der Stellung bzw. des Durchflusses durch ein Stickstoffventil zur Temperaturkontrolle verwendet werden.

Zur homogeneren Temperierung kann außerdem ein Ventilator im Kammerinneren eingesetzt werden, der eine erzwungene Konvektion erzeugt und damit Temperaturgradienten vermindert.

Eine weitere, nicht abgebildete Möglichkeit der Kühlung ist die Kontaktkühlung mit einem temperierten Kühlkörper, der beispielsweise von einem Kühlmittel in geschlossenem Kreislauf durchflossen wird und in Kontakt mit dem Festkörper gebracht wird.

Die Temperaturmessung erfolgt bevorzugt am Festkörper, insbesondere an der Aufnahmeschicht und/oder an der Unterseite des Festkörpers, bevorzugt ist die Festkörperunterseite zum Kammerboden beabstandet angeordnet, wobei zur Positionierung des Festkörpers bevorzugt eine Positioniereinrichtung vorgesehen ist, mittels der besonders bevorzugt der Abstand des Festkörpers zum Kammerboden oder der Abstand der Aufnahmeschicht zu dem flüssigen Stickstoff, insbesondere Temperaturabhängig, veränderbar ist.

Ferner ist bevorzugt eine Kammer zum Aufnehmen des Stickstoffs und der Positioniereinrichtung vorgesehen, wobei die Kammer bevorzugt verschließbar ist und/oder gegenüber der Umgebung thermisch isoliert ist.

Gemäß der vorliegenden Beschreibung wird unter einem Festkörper-Ausgangsmaterial bevorzugt ein monokristallines, polykristallines oder amorphes Material verstanden. Bevorzugt eignen sich wegen der stark anisotropen atomaren Bindungskräfte Monokristalline mit einer stark anisotropen Struktur. Das Festkörper-Ausgangsmaterial weist bevorzugt ein Material oder eine Materialkombination aus einer der Hauptgruppen 3, 4, 5 und/oder der Nebengruppe 12 des Periodensystems der Elemente, insbesondere eine Kombination aus Elementen der 3., 4., 5. Hauptgruppe und der Nebengruppe 12, wie z.B. Zinkoxid oder Cadmiumtellurid, auf.

Neben Siliziumkarbid kann das Halbleiter-Ausgangsmaterial beispielsweise auch aus Silizium, Galliumarsenid GaAs, Galliumnitrid GaN, Siliciumcarbid SiC, Indiumphosphid lnP, Zinkoxid ZnO, Aluminiumnitrid AIN, Germanium, Gallium(III)-oxid Ga₂O₃, Aluminiumoxid Al₂O₃ (Saphir), Galliumphosphid GaP, Indiumarsenid InAs, Indiumnitrid InN, Aluminiumarsenid AlAs oder Diamant bestehen.

Der Festkörper bzw. das Werkstück (z.B. Wafer) weist bevorzugt ein Material oder eine Materialkombination aus einer der Hauptgruppen 3, 4 und 5 des Periodensystems der Elemente auf, wie z.B. SiC, Si, SiGe, Ge, GaAs, InP, GaN, Al₂O₃ (Saphir), AIN. Besonders bevorzugt weist der Festkörper eine Kombination aus der vierten, dritten und fünften Gruppe des Periodensystems vorkommenden Elementen auf. Denkbare Materialien oder Materialkombinationen sind dabei z.B. Galliumarsenid, Silizium, Siliziumcarbid, etc. Weiterhin kann der Festkörper eine Keramik (z.B. Al₂O₃ - Alumiumoxid) aufweisen oder aus einer Keramik bestehen, bevorzugte Keramiken sind dabei z.B. Perovskitkeramiken (wie z.B. Pb-, O-, Ti/Zr-haltige Keramiken) im Allgemeinen und Blei-Magnesium-Niobate, Bariumtitanat, Lithiumtitanat, Yttrium-Aluminium-Granat, insbesondere Yttrium-Aluminium-Granat Kristalle für Festkörperlaseranwendungen, SAW-Keramiken (surface acoustic wave), wie z.B. Lithiumniobat, Galliumorthophosphat, Quartz, Calziumtitanat, etc. im Speziellen. Der Festkörper weist somit bevorzugt ein Halbleitermaterial oder ein Keramikmaterial auf bzw. besonders bevorzugt besteht der Festkörper aus mindestens einem Halbleitermaterial oder einem Keramikmaterial. Der Festkörper ist bevorzugt ein Ingot oder ein Wafer. Besonders bevorzugt handelt es sich bei dem Festkörper um ein für Laserstrahlen zumindest teilweise transparentes Material. Es ist somit weiterhin denkbar, dass der Festkörper ein transparentes Material aufweist oder teilweise aus einem transparenten Material, wie z.B. Saphir, besteht bzw. gefertigt ist. Weitere Materialien, die hierbei als Festkörpermaterial alleine oder in Kombination mit einem anderen Material in Frage kommen, sind z.B. "wide band gap"-Materialien, InAISb, Hochtemperatursupraleiter, insbesondere seltene Erden Cuprate (z.B. YBa₂Cu₃O₇). Es ist zusätzlich oder alternativ denkbar, dass der Festkörper eine Photomaske ist, wobei als Photomaskenmaterial im vorliegenden Fall bevorzugt jedes zum Anmeldetag bekannte Photomaskenmaterial und besonders bevorzugt Kombinationen daraus verwendet werden können. Ferner kann der Festkörper zusätzlich oder alternativ Siliziumcarbid (SiC) aufweisen oder daraus bestehen.

Die Modifikationen können eine Phasenumwandlung von Siliziumkarbid in Silizium und Kohlenstoff darstellen.

Die erfindungsgemäße Laser-Beaufschlagung bewirkt bevorzugt eine stoffspezifische ortsaufgelöste Kumulierung des Energieeintrags, woraus eine definierte Temperierung des Festkörpers an einem definierten Ort oder an definierten Orten sowie in einer definierten Zeit resultiert. In einer konkreten Anwendung kann der Festkörper aus Siliziumcarbid bestehen, wodurch bevorzugt eine stark lokal begrenzte Temperierung des Festkörpers auf eine Temperatur von z.B. mehr als 2830 +/- 40°C vorgenommen wird. Aus dieser Temperierung resultieren neue Stoffe oder Phasen, insbesondere kristalline und/oder amorphe Phasen, wobei die resultierenden Phasen bevorzugt Si- (Silizium) und DLC- (Diamond-like carbon) Phasen sind, die mit deutlich verringerter Festigkeit entstehen. Durch diese festigkeitsreduzierte Schicht ergibt sich dann der Ablösebereich bzw. die Ablöseebene.

Ferner wird die zuvor genannte Aufgabe durch einen Festkörper gelöst, der nacheinem zuvor genannten Verfahren hergestellt wurde und mindestens eine Ablöseebene im Inneren des Festkörpers aufweist, wobei die Ablöseebene aus Modifikation gebildet wird, die mittels Laserstrahlung erzeugt wurden. Ferner weist der Festkörper einen aus einem Hochtemperaturbehandlungsverfahren resultierenden Bereich auf.

Gemäß einer weiteren bevorzugten Ausführungsform sind an dem Bereich die Schichtlen und/oder Bauteil/e angeordnet oder erzeugt. Alternativ können die Schichtlen und/oder Bauteil/e an einer Oberfläche der abzutrennenden Festkörperschicht angeordnet oder erzeugt sein. Der Festkörper hat bevorzugt eine Dicke bzw. mittlere Dicke von weniger als 1000µm, insbesondere von weniger als 800µm oder 700µm oder 600µm oder 500µm oder 400µm oder 300µm oder 200µm oder 100µm oder 80µm oder 50 µm.

Gegenstand der Erfindung ist somit auch das Herstellen von Bauelementen auf einem solchen vorbehandelten/modifizierten Wafer und der modifizierte Wafer als Bauteilsubstrat selbst.

Weiterhin bezieht sich die vorliegende Erfindung gemäß Anspruch 15 auf eine Mehrkomponentenanordnung. Die erfindungsgemäße Mehrkomponentenanordnung wird dabei bevorzugt mittels Anspruch 1 oder Anspruch 2 erzeugt und weist besonders bevorzugt mindestens eine Festkörperschicht auf. Die Festkörperschicht besteht dabei bevorzugt zu mehr als 50% (massemäßig), insbesondere zu mehr als 75% (massemäßig) oder zu mehr als 90% (massemäßig) oder zu mehr als 95% (massemäßig) oder zu mehr als 98% (massemäßig) oder zu mehr als 99% (massemäßig) aus SiC, wobei die Festkörperschicht im Bereich einer ersten Oberfläche Druckspannungen erzeugende Modifikationen oder Modifikationsbestandteile aufweist, wobei die Modifikationen amorphisierte (phasenumgewandelte) Bestandteile der Festkörperschicht sind, wobei die Modifikationen näher zur ersten Oberfläche beabstandet sind oder diese mit ausbilden als zu einer zweiten Oberfläche, wobei die zweite Oberfläche parallel oder im Wesentlichen parallel zur ersten Oberfläche ausgebildet ist, wobei die erste Oberfläche eben oder im Wesentlichen eben ist und/oder wobei die zweite Oberfläche eben oder im Wesentlichen eben ist. Ferner weist die erfindungsgemäße Mehrkomponentenanordnung ebenfalls eine an der ersten Oberfläche der Festkörperschicht erzeugte Metallschicht auf. Ferner ist es möglich, dass an der zweiten Oberfläche eine oder mehrere weitere Schichten und/oder ein oder mehrere weitere Bauteile angeordnet sind, insbesondere zum Ausbilden von elektrischen Komponenten, die als horizontale oder vertikale Bauelemente eingesetzt werden können.

Bevorzugt sind die Modifikationen weniger als 200 µm, insbesondere weniger als 150 µm oder weniger als 110 µm oder weniger als 100 µm oder weniger als 75 µm oder weniger als 50 µm, von der zweiten Oberfläche beabstandet.

Eine Oberfläche ist im Sinne der vorliegenden Erfindung bevorzugt als im Wesentlichen eben anzusehen, wenn jeder Quadratzentimeter der Oberfläche beim Anliegen der Oberfläche an einer idealen glatten und ideal ebenen Oberfläche zumindest mit einem Bestandteil die ideal glatte und ideal ebene Oberfläche berührt.

Eine Oberfläche ist im Sinne der vorliegenden Erfindung bevorzugt als eben anzusehen, wenn jeder Quadratzentimeter, insbesondere Quadratmillimeter, der Oberfläche beim Anliegen der Oberfläche an einer idealen glatten und ideal ebenen Oberfläche zumindest mit mehreren, insbesondere mit mindestens 2, 3, 4 oder 5 Bestandteilen die ideal glatte und ideal ebene Oberfläche berührt.

Ferner werden die Gegenstände der am 07.12.2016 beim Deutschen Patent- und Markenamt eingereichten Patentanmeldung DE 10 2016 123 679.9 vollumfänglich durch Bezugnahme zum Gegenstand der vorliegenden Schutzrechtsschrift gemacht.

Weitere Vorteile, Ziele und Eigenschaften der vorliegenden Erfindung werden anhand nachfolgender Beschreibung anliegender Zeichnungen erläutert, in welchen beispielhaft das erfindungsgemäße Trennverfahren dargestellt ist. Bauteile oder Elemente, die in dem erfindungsgemäßen Verfahren bevorzugt eingesetzt werden und/oder welche in den Figuren wenigstens im Wesentlichen hinsichtlich ihrer Funktion übereinstimmen, können hierbei mit gleichen Bezugszeichen gekennzeichnet sein, wobei diese Bauteile oder Elemente nicht in allen Figuren beziffert oder erläutert sein müssen.

Darin zeigt:
- Fig. 1a-f: einen erfindungsgemäßen Behandlungsablauf;
- Fig. 2a-b: zwei schematische Beispiele für Festkörperanordnungen, wie sie erfindungsgemäß bereitgestellt werden können;
- Fig. 3a-i: weitere schematische Beispiele für erfindungsgemäße Festkörperanordnungen bzw. Festkörperanordnungen die im erfindungsgemäßen Verfahren - als Zwischenprodukt - erzeugt werden können;
- Fig. 4: eine schematische Darstellung von zwei durch Modifikationen ausgebildete Linien;
- Fig. 5a-d: verschiedene Kühleinrichtungen, die bevorzugt zum Kühlen im erfindungsgemäßen Verfahren einsetzbar sind,
- Fig. 6a-c: drei unterschiedliche schematische Beispiele für die Rissausbreitung zwischen Modifikationen,
- Fig. 7: unterschiedlich orientierte Modifikationslinien zur Bewirkung unterschiedlicher Funktionen,
- Fig. 8: ein Beispiel einer Schottky Diode und
- Fig. 9: ein Beispiel eines MOSFETs.

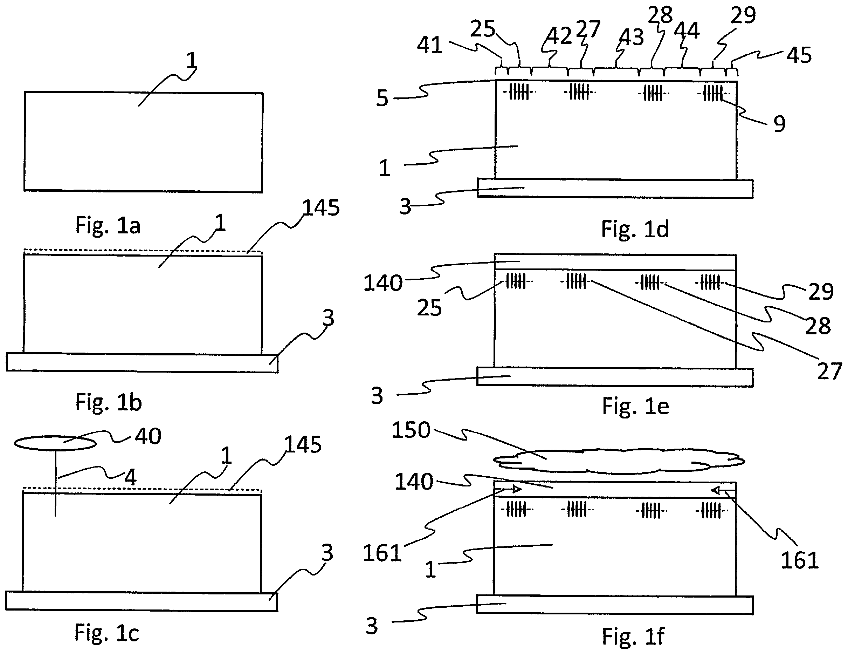

Fig. 1a zeigt die Bereitstellung des Festkörpers 1, insbesondere eines Wafers.

Gemäß Fig. 1b ist der bereitgestellte Festkörper 1 an einem Werkzeugträger (Chuck) 3 angekoppelt bzw. angeklebt oder angeschweißt oder angeschraubt oder angeklemmt, wobei der Werkzeugträger bevorzugt eine Kühlfunktionalität umfasst und dadurch bevorzugt zur Kühleinrichtung 3 wird. Der Festkörper 1 wird bevorzugt in Längsrichtung mit seiner Unterseite, die bevorzugt in Längsrichtung gegenüber der Oberfläche 5 liegt, an der Kühleinrichtung 3 fixiert, insbesondere angeklebt. Die Laserstrahlen werden somit zum Erzeugen der Modifikationen 9 über die Oberfläche 5, die Bestandteil der abzutrennenden Festkörperschicht ist, in Richtung der Kühleinrichtung 3 in den Festkörper 1 eingeleitet. Besonders bevorzugt erfolgt ferner eine Hochtemperaturbehandlung der Oberfläche 5, insbesondere eine epitaktische Materialanordnung an der Festkörperoberfläche 5, woraus bevorzugt eine weitere Schicht 145 oder mehrere weitere Schichten 145 resultieren. Das mindestens eine Hochtemperaturverfahren ist bevorzugt ein Epitaxieverfahren, ein Dotierverfahren oder ein Verfahren unter Plasmaeinsatz, wobei durch das Hochtemperaturverfahren, insbesondere im Falle eines Epitaxiverfahrens, mindestens eine Schicht 145 auf dem Festkörper 1 erzeugt wird, wobei die mindestens eine erzeugte Schicht 145 vordefinierte Parameter aufweist, wobei zumindest ein vordefinierter Parameter einen maximalen Grad an Brechung und/oder Absorption und/oder Reflexion von Laserlichtwellen vorgibt, wobei der Grad an Brechung und/oder Absorption und/oder Reflexion unter 5% und bevorzugt unter 1% und besonders bevorzugt unter 0,1% liegt. Weiterhin kann die erzeugte Schicht 145 bzw. die weiteren erzeugten Schichten 145 bevorzugt metallfrei sein.

Fig. 1c zeigt schematisch die Erzeugung der Modifikationen 9 mittels der Laserstrahlen. Die Laserstrahlen dringen dabei bevorzugt über die zuvor mittels des Hochtemperaturverfahrens erzeugte Schicht 145 in den Festkörper 1 ein. Es ist alternativ jedoch ebenfalls denkbar, dass die Laserstrahlen über eine freie, d.h. nicht mit der weiteren Schicht 145 beschichteten Oberfläche des Festkörpers 1, insbesondere von unten, in den Festkörper 1 eindringen. Hierbei wird der Festkörper 1 bevorzugt seitlich oder an den äußeren Enden (Breiten- und/oder Tiefenrichtung) gehalten.

Fig. 1d zeigt eine schematische Schnittdarstellung des Festkörper 1 nach der Erzeugung der Modifikationen 9. Gemäß diesem Beispiel sind 4 Blöcke an Modifikationen 9 erkennbar, die zu den 4 Rissanteilen 25, 27, 28, 29 führen. Angrenzend an die Blöcke mit Modifikationen 9 kennzeichnen die Bezugszeichen 41, 42, 43, 44 und 45 jeweils Bereiche ohne Modifikationen 9 oder Bereiche, in denen weniger Modifikationen 9 erzeugt sind, als in den Bereichen, in denen die Blöcke an Modifikationen 9 erzeugt sind.

Fig. 1e zeigt einen Zustand, gemäß dem eine Aufnahmeschicht, insbesondere ein Polymermaterial aufweisend, an weiteren an der Oberfläche 5 oder einer an der Oberfläche 5 zuvor epitaktisch erzeugten weiteren Schicht angeordneten Bauteilen (nicht gezeigt) angeordnet oder erzeugt wird. Die Aufnahmeschicht ist bevorzugt als Folie erzeugt worden und nach ihrer Erzeugung an die Oberfläche 5 angekoppelt, insbesondere angebondet oder angeklebt, worden. Es ist jedoch ebenfalls möglich die Aufnahmeschicht durch Aufbringung eines flüssigen Polymers auf die Oberfläche 5 und anschließendes Verfestigen auszubilden.

Zwischen dem Schritt der Erzeugung der Modifikationen und der Anbringung der Aufnahmeschicht erfolgt bevorzugt eine Anordnung bzw. Erzeugung von weiteren Schichten 150 und/oder Bauteilen 150 an der Oberfläche 5 oder an einer daran bereits während eines vorgelagerten Hochtemperaturverfahrens erzeugten weiteren Schicht 145.

Fig. 1f zeigt schematisch eine Temperierung der Aufnahmeschicht. Bevorzugt wird die Aufnahmeschicht auf eine Temperatur unterhalb der Umgebungstemperatur, insbesondere auf eine Temperatur von weniger als 20°C, oder von weniger als 1°C oder von weniger als 0°C oder von weniger als -10°C oder von weniger als -50°C oder von weniger als -60°C temperiert, insbesondere gekühlt. Wobei das Material der Aufnahmeschicht 140 infolge der Abkühlung einen Glasübergang oder und eine Kristallisation erfährt. Bevorzugt erfolgt die Temperierung der Aufnahmeschicht mittels flüssigen Stickstoffs, insbesondere mittels eines Stickstoffnebels. Aufgrund der Temperierung, insbesondere aufgrund des Glasübergangs, zieht sich die Aufnahmeschicht zusammen, wodurch mechanische Spannungen in dem Festkörper 1 erzeugt werden. Aufgrund der mechanischen Spannungen wird ein die Rissanteile 25, 27, 28, 29 verbindender Riss ausgelöst, durch den der Festkörperanteil 12 von dem Festkörper 1 abgetrennt wird.

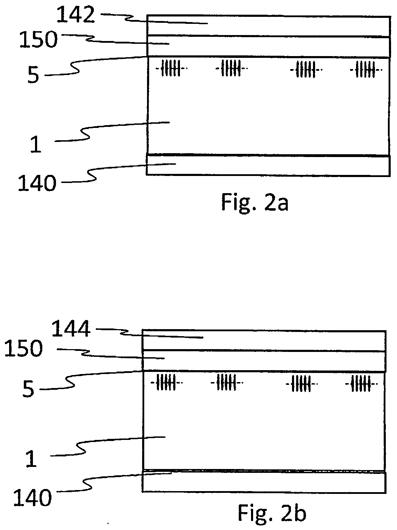

Fig. 2a zeigt eine Ausführungsform, gemäß der die Aufnahmeschicht 140 an einer Oberfläche des Festkörpers angeordnet ist, die weiter von den Modifikationen beabstandet ist als eine dazu parallele oder bevorzugt im Wesentlichen parallele oder vollständig parallele Oberfläche 5. Bevorzugt weist die Oberfläche eine weitere Schicht 145 (analog zu Fig. 1b-1f) auf. An der weiteren Schicht 145 oder an der freiliegenden Oberfläche 5 werden bevorzugt Bauteile 150 oder weitere Materialschichten 150 angeordnet. Bevorzugt wird an einer freiliegenden Oberfläche der weiteren Materialschicht 150 oder der Bauteile 150 eine Stabilisierungsschicht und/oder eine Schutzschicht 142 angeordnet oder erzeugt. Die Bauteile 150 können hierbei z.B. vergossen werden, insbesondere mit einem Polymermaterial und/oder Keramikmaterial. Zusätzlich ist vorstellbar, dass an die Stabilisierungsschicht und/oder Schutzschicht 142 eine Stabilisierungseinrichtung, insbesondere ein weiterer Wafer, wie z.B. ein Glaswafer, angekoppelt, insbesondere angeklebt bzw. angebondet wird. Der die Stabilisierungsschicht und/oder Schutzschicht 142 oder die Stabilisierungsschicht und/oder Schutzschicht 142 und die Stabilisierungseinrichtung bewirken dabei, dass sich die Bauteile 150 bzw. weiteren Materialschicht 150 beim Abspalten oder nach dem Abspalten nur unwesentlich oder nicht verformen. Beim Abspalten kann die Verformung durch die mittels der Aufnahmeschicht 140 erzeugten Kräften bewirkt werden und nach dem Abspalten kann eine Verformung durch die verbleibenden Modifikationen, insbesondere Stoffumwandlungen, bewirkt werden. Die Modifikationen bewirken im Falle einer Stoffumwandlung, dass Druckkräfte entstehen, woraus ohne die Stabilisierungsschicht / Stabilisierungseinrichtung eine Wölbung (BOW) der abgetrennten Festkörperschicht resultieren würde.

Eine Einheit aus abgetrennter Festkörperschicht und daran angeordneter Stabilisierungsschicht und/oder Schutzschicht 142 und eventuell daran angeordneter Stabilisierungseinrichtung wird dann bevorzugt zur Stressentfernung weiterbehandelt. Besonders bevorzugt bildet die Stabilisierungsschicht 142 oder die Stabilisierungseinrichtung eine Halteeinrichtung aus, mittels der die abgetrennte Festkörperschicht für eine Materialabtragbehandlung gegenüber einer Materialabtrageinrichtung, insbesondere einer Schleif- und/oder Poliereinrichtung, fixierbar ist. Mittels der Materialabtrageinrichtung werden dann die an der abgetrennten Festkörperschicht verbleibenden Modifikationsanteile abgetragen, insbesondere spanend entfernt.

Im Kontext dieser Erfindung ist die Festkörperschicht bevorzugt immer dünner als der verbleibende Festkörperanteil. Es ist jedoch ferner denkbar, dass die Aufnahmeschicht nicht an einer Oberfläche der späteren Festkörperschicht angeordnet oder erzeugt wird, sondern an einer Oberfläche des verbleibenden Festkörperanteils. Wenn es sich bei dem Festkörpermaterial um Silizium handelt, dann weist die abgetrennte Festkörperschicht gegenüber dem verbleibenden Festkörper bevorzugt ein Höhe von weniger als 40% der Höhe des verbleibenden Festkörpers auf, insbesondere von weniger als 30% oder 20% der Höhe des verbleibenden Festkörpers. Bei Silizium werden bevorzugt vorbestimmte Parameter für die Modifikationserzeugung vorgesehen, die Numerische Apertur liegt bevorzugt zwischen 0,5 und 0,8, insbesondere bei 0,65, die Einstrahltiefe liegt zwischen 150µm und 1000µm, insbesondere bei 300µm, der Pulsabstand liegt zwischen 1µm und 5µm, insbesondere bei 2µm, der Linienabstand liegt zwischen 1µm und 5µm, insbesondere bei 2 µm, die Pulsdauer liegt zwischen 50ns und 400ns, insbesondere bei 300ns, und die Pulsenergie liegt zwischen 3µJ und 30µJ, insbesondere bei 10µJ.

Ist das Material SiC, dann weist die abgetrennte Festkörperschicht gegenüber dem verbleibenden Festkörper bevorzugt eine Höhe von weniger als 50% der Höhe des verbleibenden Festkörpers auf, insbesondere von weniger als 45% oder 40% oder 35% oder 30% oder 25% der Höhe des verbleibenden Festkörpers. Bei SiC werden bevorzugt vorbestimmte Parameter für die Modifikationserzeugung vorgesehen, die Numerische Apertur liegt bevorzugt zwischen 0,4 und 0,8, insbesondere bei 0,4, die Einstrahltiefe liegt bevorzugt zwischen 50µm und 500µm, insbesondere bei 180µm, der Pulsabstand liegt bevorzugt zwischen 0,1 µm und 3µm, insbesondere bei 1µm, der Linienabstand liegt bevorzugt zwischen 10µm und 100µm, insbesondere bei 75 µm, die Pulsdauer liegt bevorzugt zwischen 1fs und 10ns, insbesondere bei 3ns, und die Pulsenergie liegt bevorzugt zwischen 0,5µJ und 30µJ, insbesondere bei 7µJ.

Auch in Fig. 2b kann analog zu den Fig. 1b-1f eine weitere Schicht 145 erzeugt sein, auch wenn diese nicht kenntlich gemacht wurde. Die weiteren Materialschichten oder Bauteile 150 werden daher bevorzugt an der weiteren Schicht 145 oder an einer freiliegenden Oberfläche des Festkörpers erzeugt bzw. angeordnet.

Ferner zeigt Fig. 2b, dass an einer Oberfläche des verbleibenden Festkörpers die Aufnahmeschicht angeordnet sein kann und an den Bauteilen oder weiteren Materialschichten 150 eine weitere Aufnahmeschicht 146 angeordnet sein kann. Die Bauteile können hierbei zusätzlich mit einer Stabilisierungsschicht 142 versehen sein, wodurch die weitere Aufnahmeschicht 146 bevorzugt an der Stabilisierungsschicht und oder Schutzschicht 142 angeordnet oder erzeugt ist. Die weitere Aufnahmeschicht 146 wird bevorzugt als Folie bereitgestellt und besteht bevorzugt ebenfalls zumindest teilweise aus einem Polymermaterial. Besonders bevorzugt weist die weitere Aufnahmeschicht 146 das gleiche Material auf wie die Aufnahmeschicht 140 bzw. 142. Diese Ausführungsform ist vorteilhaft, da die Spannungen zum Erzeugen des Risses von zwei Seiten in den Festkörper eingeleitet werden können.

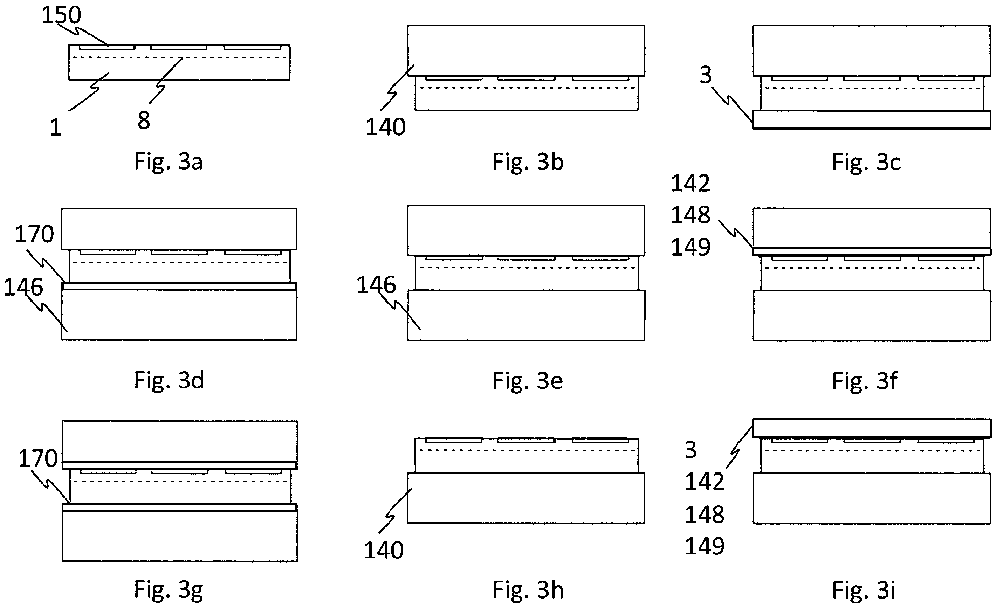

Die Figuren 3a bis 3i zeigen verschiedene Anordnungen, die nach der Erzeugung der weiteren Materialschichten bzw. Bauteile 150 zum Einleiten des Risses vorgesehen werden können.

Die Figuren 3a-3i zeigen diverse Festkörperanordnungen 176, wie sie zum Einleiten von Rissführungs- und/oder Rissauslösungsspannungen vorteilhaft sind.

Fig. 3a zeigt hierbei einen prozessierter Festkörper 1 bzw. Wafer mit Strukturen bzw. Bauteilen 150.

Gegenüber dem in Fig. 3a gezeigten Festkörper 1 ist bei dem in Fig. 3b gezeigten Festkörper 1 eine Aufnahmeschicht 140 an der Bauteilseite, insbesondere an den Bauteilen 150 bzw. den weiteren Materialschichten 150, angeordnet oder erzeugt. Die Aufnahmeschicht 140 ist hierbei bevorzugt an der abzutrennenden Festkörperschicht angeordnet. Die Aufnahmeschicht 140 kann hierbei auch als Splitfolie bezeichnet werden und ist somit bevorzugt auf der Strukturseite auflaminiert. Im Nachfolgeschritt erfolgt dann ein Abkühlen der Gesamtanordnung, wodurch der Split bzw. die Rissauslösung und/oder Rissführung bewirkt wird.

Gegenüber der Darstellung der Fig. 3b ist gemäß der Fig. 3c an der Unterseite des Festkörpers bzw. an der freiliegenden Oberfläche des Festkörpers eine Halteschicht/gebondeter Wafer angeordnet. Es kann sich bei der Halteschicht auch um einen Werkzeugträger bzw. Chuck 3 handeln. Im Nachfolgeschritt erfolgt dann ein Abkühlen der Gesamtanordnung, wodurch der Split bzw. die Rissauslösung und/oder Rissführung bewirkt wird.

Fig. 3d zeigt gegenüber der Fig. 3b eine Anordnung, gemäß welcher der Festkörper doppelseitig mit Aufnahmeschichten 140, 146 versehen ist. Die weitere Aufnahmeschicht 146 ist dabei an einer Oberfläche des später verbleibenden Restfestkörpers angeordnet, wobei zwischen der weiteren Aufnahmeschicht 146 und dem Festkörper 1 eine Haftvermittlungsschicht 148 und/oder Opferschicht 149 und/oder Schutzschicht 142 angeordnet oder erzeugt sein kann. Die beiden Aufnahmeschichten 140 und 146 sind bevorzugt auflaminiert. Im Nachfolgeschritt erfolgt dann ein Abkühlen der Gesamtanordnung, wodurch der Split bzw. die Rissauslösung und/oder Rissführung bewirkt wird.

Fig. 3e zeigt eine Anordnung, gemäß der gegenüber der aus Fig. 3d bekannten Anordnung keine Haftvermittlungsschicht 148 und/oder Opferschicht 149 und/oder Schutzschicht 142 zwischen der weiteren Aufnahmeschicht 146 und dem Festkörper 1 angeordnet oder erzeugt ist. Im Nachfolgeschritt erfolgt dann ein Abkühlen der Gesamtanordnung, wodurch der Split bzw. die Rissauslösung und/oder Rissführung bewirkt wird.

Fig. 3f zeigt eine Anordnung die invers zu der aus Fig. 3d bekannten Anordnung aufgebaut ist, d.h., dass die Haftvermittlungsschicht 148 und/oder Opferschicht 149 und/oder Schutzschicht 142 nicht zwischen der weiteren Aufnahmeschicht 146 und dem Festkörper 1 angeordnet oder erzeugt ist, sondern zwischen der Aufnahmeschicht 140 und dem Festkörper 1 und somit an der abzutrennenden Festkörperschicht erzeugt oder angeordnet ist/sind. Auf den Bauteilen 150 oder den Strukturen kann hierbei z.B. mittels Spinncoating eine oder mehrere Schichten erzeugt werden. Als Nachfolgeschritt erfolgt dann ein Abkühlen der Gesamtanordnung, wodurch der Split bzw. die Rissauslösung und/oder Rissführung bewirkt wird.

Fig. 3g zeigt eine Anordnung bzw. Ausprägung, die einer Kombination aus den Anordnungen der Figuren 3d und 3f entspricht. Der Festkörper ist bevorzugt doppelseitig mit Splitfolie laminiert, ebenso kann doppelseitig eine Schutzschicht und/oder Haftvermittlungsschicht und/oder Opferschicht unter der Splitfolie vorgesehen sein, auf den Strukturen ist ferner z.B. Spincoating möglich. Als Nachfolgeschritt erfolgt dann ein Abkühlen der Gesamtanordnung, wodurch der Split bzw. die Rissauslösung und/oder Rissführung bewirkt wird.

Fig. 3h zeigt eine Anordnung, die ähnlich zur in Fig. 3b gezeigten Anordnung ist, wobei die Aufnahmeschicht nicht auf einer Oberfläche der abzutrennenden Festkörperschicht, sondern auf dem nach der Abtrennung verbleibenden Restfestkörper einseitig angeordnet bzw. laminiert ist. Die Abtrennung erfolgt dann infolge der Abkühlung analog zur Abtrennung von einem Ingot bzw. wie in einem Ingot-Prozess.

Fig. 3i zeigt eine Anordnung, die ähnlich zur aus Fig. 3c bekannten Anordnung ist, wobei eine oder mehrere der nachfolgend genannten Schichten oder Einrichtungen an der Bauteilseite des Festkörpers bzw. an oder oberhalb der Bauteile 150 angeordnet oder erzeugt wird/werden. Diese Schichten oder Einrichtungen sind dabei bevorzugt: Mindestens oder genau eine Haftvermittlungsschicht 148 und/oder mindestens oder genau eine Opferschicht 149 und/oder mindestens oder genau eine Schutzschicht 142 und/oder mindestens oder genau eine Stabilisierungseinrichtung 3, insbesondere ein Werkzeugträger oder Chuck oder ein weiterer Wafer. Als Nachfolgeschritt erfolgt dann ein Abkühlen der Gesamtanordnung, wodurch der Split bzw. die Rissauslösung und/oder Rissführung bewirkt wird.

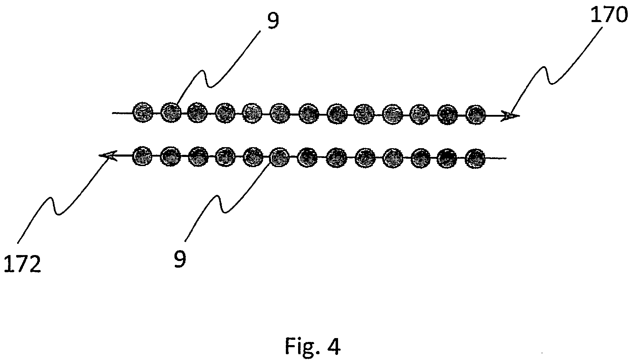

Fig. 4 zeigt eine Illustration eines Beispiels für ein Schreibmuster bei einer X-Y-Bearbeitung: Pfeile 170, 172 repräsentieren die Laservorschubrichtung, die schwarzen Kreise repräsentieren die unterschiedlichen Laserschüsse bzw. Modifikationen 9, die hier mit ihrer Schadwirkung im Material nicht überlappen. Es ist hierbei bevorzugt, wenn der Laser zunächst in eine Richtung fährt und Modifikationen 9 erzeugt, bevor er umkehrt und Modifikationen 9 in der zweiten (unteren) Richtung schreibt.

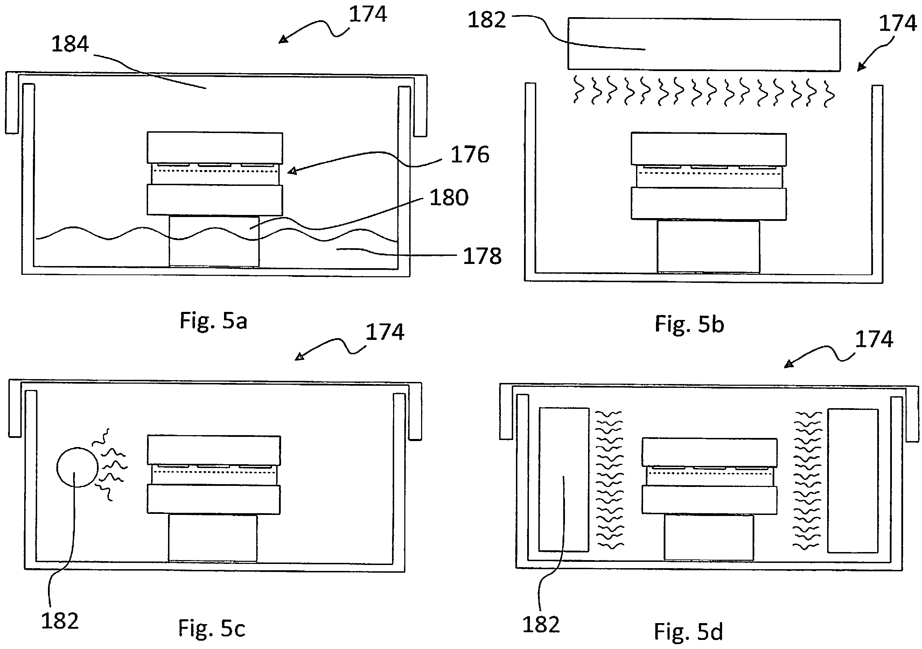

Die Figuren 5a bis 5d zeigen verschiedene Kühleinrichtungen 174. Die in diesen Kühleinrichtungen 174 prozessierten Festkörperanordnungen 176 resultieren aus den verschiedenen in den Figuren 1a bis 3i gezeigten und beschriebenen Ausprägungen bzw. Gestaltungen der mit einer oder mehreren Aufnahmeschichtlen 140, 146 versehenen Festkörper 1. Die hierin gezeigten Kühleinrichtungen 174 verwenden alle zum Kühlen ein verfüssigtes Gas 178 als Ausgangskühlmedium. Dieses Ausgangskühlmedium wird je nach Ausführungsform entweder vernebelt oder verdampft. Bevorzugt handelt es sich bei dem Ausgangskühlmedium um flüssigen Stickstoff. Alternative Kühlverfahren z.B. mittels Peltierelementen sind ebenfalls vorstellbar und möglich.

Die Kühleinrichtung 174 dient dabei bevorzugt zum Abkühlen der Aufnahmeschicht 140, 146 auf eine Temperatur zwischen -130°C und -10°C, insbesondere auf eine Temperatur zwischen -80°C und -50°C.

Gemäß Fig. 5a weist die Kühleinrichtung 174 ein Stickstoffbad auf, wobei die Aufnahmeschicht beabstandet, insbesondere mittels einer einstellbaren Positioniereinrichtung 180, zu in dem Stickstoffbad vorgehaltenen flüssigen Stickstoff positioniert wird. Somit wird die Festkörperanordnung bevorzugt auf einer Positioniereinrichtung bzw. auf einer Halterung über einem Stickstoffbad angeordnet. Es resultiert somit ein Temperaturgradient über die Kammerhöhe und die Temperatur an der Festköperanordnung ist über die Füllhöhe mit dem Ausgangskühlmedium oder die Position der Festkörperanordnung 176 (Abstand zum Boden der Kammer) einstellbar.

Gemäß den Ausführungsformen der Figuren 5b bis 5d kann die Kühleinrichtung bevorzugt ein Vernebelungsmittel, insbesondere mindestens oder genau eine perforierte Rohrleitung, zum Vernebeln von flüssigem Stickstoff oder ein Vernebelungsmittel zum Vernebeln von flüssigem Stickstoff aufweisen und die Kühlwirkung durch vernebelten oder verdampften Stickstoff erzeugt werden.

Gemäß Fig. 5b wird bevorzugt ein homogenes Sprühgerät/Nebler zum Sprühen oder Vernebeln bereitgestellt. Das Sprühen oder Vernebeln erfolgt bevorzugt oberhalb der Festkörperanordnung 176. Ferner erfolgen bevorzugt Temperaturmessungen zur Temperaturkontrolle, die Ausgangsdaten zum Regelten eines Ventils, insbesondere Stickstoffventils, ausgeben. Die Temperaturmessungen erfolgen bevorzugt am Substrat bzw. am Festkörper 1 oder an der Aufnahmeschicht 140.

Das Substrat bzw. der Festkörper 1 bzw. die Festkörperanordnung 176 ruht bevorzugt über dem Kammerboden um Stickstoffabsetzen am Boden der Kammer auszuweichen.

Gemäß Fig. 5c wird bevorzugt eine perforierte Rohrleitung als homogenes Sprühgerät verwendet. Ferner erfolgen bevorzugt Temperaturmessungen zur Temperaturkontrolle, die Ausgangsdaten zum Regelten eines Ventils, insbesondere Stickstoffventils, ausgeben. Die Temperaturmessungen erfolgen bevorzugt am Substrat bzw. am Festkörper 1 oder an der Aufnahmeschicht 140.

Das Substrat bzw. der Festkörper 1 bzw. die Festkörperanordnung 176 ruht bevorzugt über dem Kammerboden um Stickstoffabsetzen am Boden der Kammer auszuweichen.

Gemäß Fig. 5d zeigt eine Kühleinrichtung 176 die ein homogenes Sprühgerät/Nebler 182 zum Kühlen von bevorzugt mehreren bzw. jeder Seite aufweist. Ferner erfolgen bevorzugt Temperaturmessungen zur Temperaturkontrolle, die Ausgangsdaten zum Regelten eines Ventils, insbesondere Stickstoffventils, ausgeben. Die Temperaturmessungen erfolgen bevorzugt am Substrat bzw. am Festkörper 1 oder an der Aufnahmeschicht 140.

Das Substrat bzw. der Festkörper 1 bzw. die Festkörperanordnung 176 ruht bevorzugt über dem Kammerboden um Stickstoffabsetzen am Boden der Kammer auszuweichen.

Die Kammer 184 der Kühleinrichtung 174 ist bevorzugt verschlossen um einen Temperaturgradient möglichst durch Isolation zu vermindern.

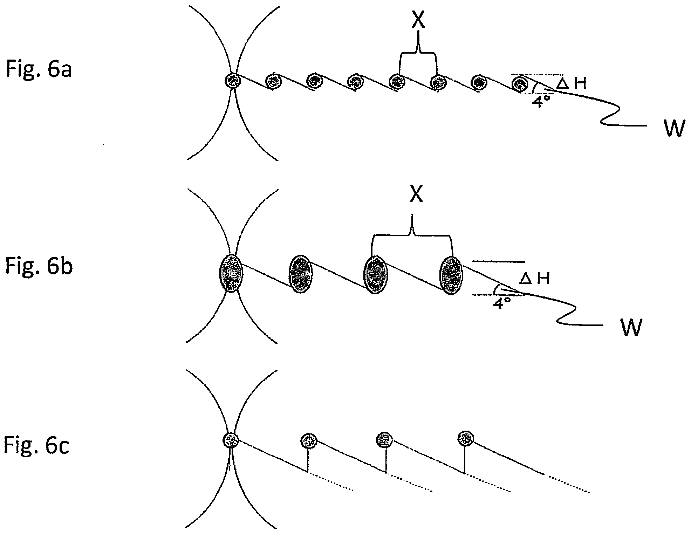

Fig. 6 zeigt drei Beispiele für bevorzugte Zusammenhänge zwischen der Kristallgitterorientierung und der Modifikationserzeugung. Dieses Verfahren ist insbesondere für das Abtrennen von Festkörperschichten von einem aus SiC bestehenden oder SiC aufweisenden Festkörper sinnvoll. Durch diese Zusammenhänge ergibt sich ein weiteres erfindungsgemäßes Verfahren. Dieses weitere erfindungsgemäße Verfahren dient bevorzugt zum Abtrennen von mindestens einer Festkörperschicht 4 von mindestens einem Festkörper 1, insbesondere von einem Wafer von einem Ingot oder zum Dünnen eines Wafers. Das weitere erfindungsgemäße Verfahren umfasst dabei bevorzugt mindestens die Schritte: Erzeugung einer Vielzahl an Modifikationen 9 mittels Laserstrahlen im Inneren des Festkörpers 1 zum Ausbilden einer Ablöseebene 8, und Einleiten einer äußeren Kraft in den Festkörper 1 zum Erzeugen von Spannungen in dem Festkörper 1, wobei die äußere Kraft so stark ist, dass die Spannungen eine Rissausbreitung entlang der Ablöseebene 8 bewirkt.

Erfindungsgemäß werden die Modifikationen nacheinander in mindestens einer Zeile oder Reihe oder Linie erzeugt, wobei die in einer Zeile oder Reihe oder Linie erzeugten Modifikationen 9 bevorzugt in einem Abstand X und mit einer Höhe H erzeugt werden, damit ein sich zwischen zwei aufeinander folgenden Modifikationen ausbreitender Riss, insbesondere in Kristallgitterrichtung ausbreitender Riss, dessen Rissausbreitungsrichtung in einem Winkel W gegenüber der Ablöseebene ausgerichtet ist, die beiden Modifikationen miteinander verbindet. Der Winkel W liegt hierbei bevorzugt zwischen 0° und 6°, insbesondere bei 4°. Bevorzugt breitet sich der Riss von einem Bereich unterhalb des Zentrums einer ersten Modifikation hin zu einem Bereich oberhalb des Zentrums einer zweiten Modifikation hin aus. Der hierbei wesentliche Zusammenhang ist daher, dass die Größe der Modifikation in Abhängigkeit des Abstands der Modifikationen und des Winkels W verändert werden kann bzw. muss.

Ferner kann dieses Verfahren auch den Schritt des Erzeugens einer Kompositstruktur durch Anordnen oder Erzeugen von Schichten und/oder Bauteilen 150 an oder oberhalb einer zunächst freiliegenden Oberfläche 5 des Festkörpers 1 aufweisen, wobei die freiliegende Oberfläche 5 bevorzugt Bestandteil der abzutrennenden Festkörperschicht 4 ist. Besonders bevorzugt werden die Modifikationen zum Ausbilden der Ablöseebene 8 vor der Erzeugung der Kompositstruktur erzeugt.

Zum Einleiten der äußeren Kraft kann z.B. analog zu den zuvor beschriebenen Verfahren eine Aufnahmeschicht 140 an einer freiliegenden Oberfläche 5 der Kompositstruktur bzw. des Festkörpers angeordnet werden.

Die drei Abbildungen 6a bis 6c sollen verdeutlichen, wie die Größe der durch Laser amorphisierten/phasenumgewandelten Schad-/Modifikationszone die vom Sägezahnmuster des Risses durchlaufene Höhe beeinflusst. Generell läuft der Riss entlang der Kristallebenen also zwischen einzelnen Atomen des Kristalls. In der modifizierten Zone sind diese klaren Ebenen nicht mehr existent, der kommt also zum Halt.

Durch eine bevorzugt möglichst hohe numerische Apertur kann die Schadzone entlang der Strahlrichtung verkleinert werden, wie auch lateral in der Brennebene. Da nur die Schwellintensität erreicht werden muss, genügt hier dann auch eine kleinere Pulsenergie.

Wenn nun die Schadzone geeigneter weise kleiner ausgebildet ist, so können die Lasermodifikationen dichter gesetzt werden, was den Sägezahn kürzer laufen lässt und insgesamt eine geringere Höhenausdehnung der modifizierten Ebene bedingt (erstes Bild).

Ist die Schadzone hingegen größer ausgebildet (höhere Energie und/oder niedrigere numerische Apertur - Fig. 6b) - wird durch den erhöhten Druck der amorphisierten Zone auch ein größerer Mikroriss ausgelöst, den einzufangen (d.h. kontrolliert zu stoppen) man mit einer Schadzone größerer Ausdehnung in größerem Abstand ermöglicht.

Fig. 6c schließlich zeigt die Gefahr auf, wenn die Schadzone nicht ausreichend groß ist und zu weit laufende Risse durch die Lasermodifikation ausgelöst werden, die Risse laufen zum einen zu weit - d.h. der durch die Risse entstandene Höhenunterschied wird größer als gewünscht - und zum anderen werden die Risse unter den weiteren Schadzonen hindurchgetrieben und nicht vom amorphisierten Material gestoppt. Dies führt dann wieder zu Materialverlusten, da alle eingerissenen Materialschichten für das Endprodukt oder eine erneute Laserbearbeitung entfernt werden müssen.

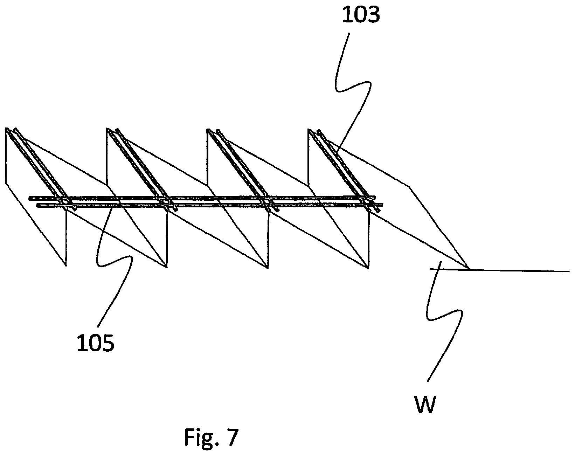

Fig. 7 zeigt eine schematisch dargestellte Momentaufnahme aus einem weiteren erfindungsgemäßen Verfahren. Dieses weitere Verfahren dient bevorzugt zum Abtrennen von mindestens einer Festkörperschicht 4 von mindestens einem Festkörper 1, insbesondere von einem Wafer von einem Ingot oder zum Dünnen eines Wafers. Das weitere erfindungsgemäße Verfahren umfasst dabei bevorzugt mindestens die Schritte: Erzeugung einer Vielzahl an Modifikationen 9 mittels Laserstrahlen im Inneren des Festkörpers 1 zum Ausbilden einer Ablöseebene 8, und Einleiten einer äußeren Kraft in den Festkörper 1 zum Erzeugen von Spannungen in dem Festkörper 1, wobei die äußere Kraft so stark ist, dass die Spannungen eine Rissausbreitung entlang der Ablöseebene 8 bewirkt.

Erfindungsgemäß werden in einem ersten Schritt die Modifikationen auf einer Linie 103 und bevorzugt im gleichen Abstand zueinander erzeugt. Weiterhin ist vorstellbar dass eine Vielzahl dieser im ersten Schritt erzeugten Linien erzeugt werden. Diese ersten Linien werden besonders bevorzugt parallel zur Rissausbreitungsrichtung uns bevorzugt geradlinig oder kreisbogenförmig, insbesondere in derselben Ebene, erzeugt. Nach der Erzeugung dieser ersten Linien werden bevorzugt zweite Linien 105 zum Auslösen und/oder Treiben von bevorzugt unterkritischen Rissen erzeugt. Diese zweiten Linien werden ebenfalls bevorzugt geradlinig erzeugt. Besonders bevorzugt sind die zweiten Linien gegenüber den ersten Linien geneigt, insbesondere orthogonal ausgerichtet. Die zweiten Linien erstrecken sich bevorzugt in derselben Ebene wie die ersten Linien oder besonders bevorzugt in einer Ebene die parallel zu der Ebene ist, in der sich die ersten Linien erstrecken. Anschließende werden bevorzugt dritte Linien erzeugt zum Verbinden der unterkritischen Risse erzeugt.

Dieses Verfahren ist insbesondere für das Abtrennen von Festkörperschichten von einem aus SIC bestehenden oder SiC aufweisenden Festkörper sinnvoll.

Ferner können die Modifikationen nacheinander in mindestens einer Zeile oder Reihe oder Linie erzeugt werden, wobei die in einer Zeile oder Reihe oder Linie erzeugten Modifikationen 9 bevorzugt in einem Abstand X und mit einer Höhe H erzeugt werden, damit ein sich zwischen zwei aufeinander folgenden Modifikationen ausbreitender Riss, insbesondere in Kristallgitterrichtung ausbreitender Riss, dessen Rissausbreitungsrichtung in einem Winkel W gegenüber der Ablöseebene ausgerichtet ist, die beiden Modifikationen miteinander verbindet. Der Winkel W liegt hierbei bevorzugt zwischen 0° und 6°, insbesondere bei 4°. Bevorzugt breitet sich der Riss von einem Bereich unterhalb des Zentrums einer ersten Modifikation hin zu einem Bereich oberhalb des Zentrums einer zweiten Modifikation hin aus. Der hierbei wesentliche Zusammenhang ist daher, dass die Größe der Modifikation in Abhängigkeit des Abstands der Modifikationen und des Winkels W verändert werden kann bzw. muss.

Ferner kann dieses Verfahren auch den Schritt des Erzeugens einer Kompositstruktur durch Anordnen oder Erzeugen von Schichten und/oder Bauteilen 150 an oder oberhalb einer zunächst freiliegenden Oberfläche 5 des Festkörpers 1 aufweisen, wobei die freiliegende Oberfläche 5 bevorzugt Bestandteil der abzutrennenden Festkörperschicht 4 ist. Besonders bevorzugt werden die Modifikationen zum Ausbilden der Ablöseebene 8 vor der Erzeugung der Kompositstruktur erzeugt.

Zum Einleiten der äußeren Kraft kann z.B. analog zu den zuvor beschriebenen Verfahren eine Aufnahmeschicht 140 an einer freiliegenden Oberfläche 5 der Kompositstruktur bzw. des Festkörpers angeordnet werden.

Somit wird im weiteren erfindungsgemäßen Laserverfahren bevorzugt auf SiC (aber auch anderen Materialien) Linien parallel zur Rissausbreitungsrichtung (bevorzugt Querlinien genannt) erzeugt, um zunächst eine Ebene für die bevorzugte Rissauslösung zu definieren (Rissinitialisierung), bevor Längslinien die Risse treiben. Hierbei werden die Risse erst quer, dann längs initialisiert, bevor ein finaler Schritt Linien zwischen die Längslinien des zweiten Schritts setzt um die Risse vollflächig auszulösen. Dies ermöglicht kürzere Risslaufwege, was die finale Oberflächenrauhigkeit minimiert. Beispielbild für Querlinien (mit dem Sägezahn) und Rissauslöselinien (auf den Wellenkämmen des Sägezahns).

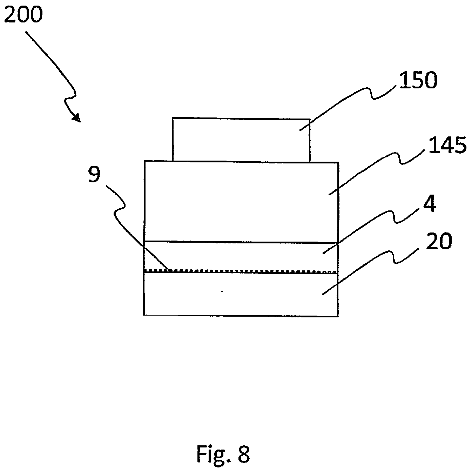

Fig. 8 zeigt exemplarisch eine Schottky Diode 200. Diese Diode 200 weist dabei bevorzugt eine Festkörperschicht 4 auf, die wiederum mittels Laserstrahlung modifizierte Anteile, insbesondere Modifikationen 9, aufweist. Die Modifikationen 9 sind hierbei in der Nähe einer ersten Oberfläche der Festkörperschicht 4 erzeugt. An dieser ersten Oberfläche der Festkörperschicht 4 ist dabei bevorzugt eine Metallschicht 20, insbesondere mittels Sputtern oder chemischer Abscheidung, erzeugt worden. Die Festkörperschicht 4 weist gegenüber der ersten Oberfläche eine zweite Oberfläche auf, an der, insbesondere mittels eines Epitaxiverfahrens, eine weitere Schicht 145 erzeugt ist. Die Festkörperschicht 4 besteht dabei bevorzugt aus hochdotiertem SiC bzw. weist hochdotiertes SiC auf und die erzeugte Schicht 145 besteht bevorzugt aus schwach dotiertem SiC oder weist schwach dotiertes SiC auf. Schwachdotiert bedeutet hierbei bevorzugt weniger dotiert als hochdotiert. Somit weist die erzeugte Schicht 145 bevorzugt je Volumeneinheit weniger Dotierung auf als die Festkörperschicht 4. Das Bezugszeichen 150 kennzeichnet einen Schottkykontakt.

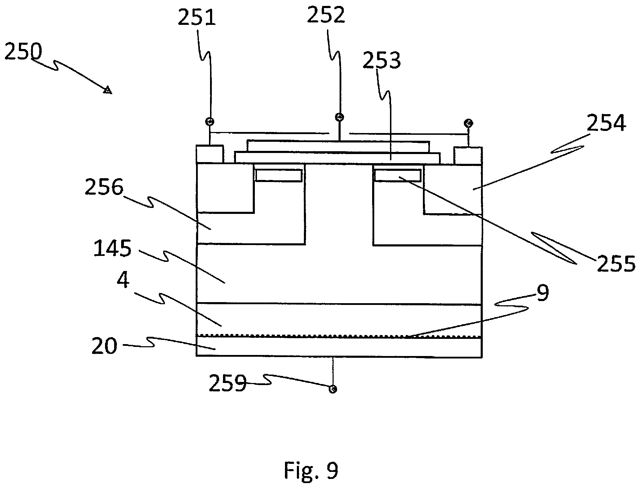

Fig. 9 zeigt exemplarisch den Aufbau eines MOSFETs 250. Dieser MOSFET 250 weist dabei bevorzugt eine Festkörperschicht 4 auf, die wiederum mittels Laserstrahlung modifizierte Anteile, insbesondere Modifikationen 9, aufweist. Die Modifikationen 9 sind hierbei in der Nähe einer ersten Oberfläche der Festkörperschicht 4 erzeugt. An dieser ersten Oberfläche der Festkörperschicht 4 ist dabei bevorzugt eine Metallschicht 20, insbesondere mittels Sputtern oder chemischer Abscheidung, erzeugt worden. Die Metallschicht 20 bildet dabei bevorzugt über einen Anschluss 259 einen Drain (high) aus. Die Festkörperschicht 4 weist gegenüber der ersten Oberfläche eine zweite Oberfläche auf. An der zweiten Oberfläche ist eine weitere Schicht, insbesondere n type SiC, ausgebildet, insbesondere erzeugt oder angeordnet. Das Bezugszeichen 256 kennzeichnet eine weitere Material bzw. Element, insbesondere p type SiC. Das Bezugszeichen 254 steht für n+. Das Bezugszeichen 255 kennzeichnet bevorzugt einen oder mehrere Kanäle, insbesondere zum Leiten des Stroms. Die mit dem Bezugszeichen 253 gekennzeichnete Lage/Sicht besteht bevorzugt aus SiO2 oder weist solches auf. Das Bezugszeichen 251 kennzeichnet eine Quelle (low) und das Bezugszeichen 252 kennzeichnet ein Gate.

Die vorliegende Erfindung kann sich somit auf ein Verfahren zum Bereitstellen von mindestens einer Festkörperschicht 4 beziehen, wobei die Festkörperschicht 4 von einem Festkörper 1 abgetrennt wird. Das erfindungsgemäße Verfahren umfasst dabei bevorzugt die Schritte:
Erzeugung einer Vielzahl an Modifikationen 9 mittels Laserstrahlen im Inneren des Festkörpers 1 zum Ausbilden einer Ablöseebene 8, wobei durch die Modifikationen 9 Druckspannungen im Festkörper 1 erzeugt werden, Abtrennen der Festkörperschicht 4 durch eine Separation des verbleibenden Festkörpers 1 und der Festkörperschicht 4 entlang der durch die Modifikationen 9 ausgebildeten Ablöseebene 8, wobei zumindest Bestandteile der die Druckspannungen erzeugenden Modifikationen 9 an der Festkörperschicht 4 verbleiben, wobei so viele Modifikationen 9 erzeugt werden, dass sich die Festkörperschicht 4 aufgrund der Modifikationen 9 vom Festkörper 1 ablöst oder wobei einer äußeren Kraft in den Festkörper 1 zum Erzeugen von weiteren Spannungen in dem Festkörper 1 eingeleitet wird, wobei die äußere Kraft so stark ist, dass die Spannungen eine Rissausbreitung entlang der durch die Modifikationen ausgebildeten Ablöseebene 8 bewirken, Erzeugen einer Metallschicht an der durch die Abtrennung der Festkörperschicht 4 von dem Festkörper 1 freigelegten Oberfläche zum zumindest teilweisen und bevorzugt mehrheitlichen und besonders bevorzugt vollständigen Kompensieren einer durch die Druckspannungen der verbleibenden Modifikationsbestandteile bewirkten Verformung der Festkörperschicht 4 oder zum zumindest teilweisen und bevorzugt mehrheitlichen oder vollständigen Kompensieren der Druckspannungen, siehe Anspruch 1.

Weiter kann sich die vorliegende Erfindung auf ein Verfahren zum Erzeugen von elektrischen Komponenten unter Verwendung des Verfahrens nach Anspruch 1 beziehen, siehe Anspruch 2.

## Patentansprüche

1. Verfahren zum Bereitstellen mindestens einer Festkörperschicht (4), wobei die Festkörperschicht (4) von einem Festkörper (1 ) abgetrennt wird und wobei das Verfahren mindestens umfasst:
Erzeugen einer Vielzahl an Modifikationen (9) mittels Laserstrahlen im Inneren des Festkörpers (1 ) zum Ausbilden einer Ablöseebene (8), wobei durch die Modifikationen (9) Druckspannungen im Festkörper (1) erzeugt werden,
Abtrennen der Festkörperschicht (4) durch eine Separation des verbleibenden Festkörpers (1) und der Festkörperschicht (4) entlang der durch die Modifikationen (9) ausgebildeten Ablöseebene (8), wobei zumindest Bestandteile der die Druckspannungen erzeugenden Modifikationen (9) an der Festkörperschicht (4) verbleiben,
wobei so viele Modifikationen (9) erzeugt werden, dass sich die Festkörperschicht (4) aufgrund der Modifikationen (9) vom Festkörper (1 ) ablöst oder
wobei eine äußere Kraft in den Festkörper (1 ) zum Erzeugen von weiteren Spannungen in dem Festkörper (1) eingeleitet wird, wobei die äußere Kraft so stark ist, dass die Spannungen eine Rissausbreitung entlang der durch die Modifikationen ausgebildeten Ablöseebene (8) bewirken,
wobei das Verfahren **gekennzeichnet ist durch**
Erzeugen einer Metallschicht (20) an der durch die Abtrennung der Festkörperschicht (4) von dem Festkörper (1) freigelegten Oberfläche zum zumindest teilweisen und bevorzugt mehrheitlichen und besonders bevorzugt vollständigen Kompensieren einer durch die Druckspannungen der verbleibenden Modifikationsbestandteile bewirkten Verformung der Festkörperschicht (4) oder zum zumindest teilweisen und bevorzugt mehrheitlichen oder vollständigen Kompensieren der Druckspannungen.

2. Verfahren nach Anspruch 1, zum Erzeugen von elektrischen Komponenten, wobei das Verfahren weiterhin umfasst:
Erzeugen einer Kompositstruktur durch Anordnen oder Erzeugen von Schichten und/oder Bauteilen (150) an oder oberhalb einer zunächst freiliegenden Oberfläche (5) des Festkörpers (1), wobei die freiliegende Oberfläche (5) Bestandteil der abzutrennenden Festkörperschicht (4) ist.

3. Verfahren nach Anspruch 1 oder 2,
wobei die Metallschicht in einem ersten Aggregatzustand und einer Temperatur oberhalb der Raumtemperatur an der Festkörperschicht (4) erzeugt wird und bei Raumtemperatur in einem zweiten Aggregatzustand vorliegt,
wobei durch den Übergang vom ersten Aggregatzustand in den zweiten Aggregatzustand die Metallschicht die Festkörperschicht zum zumindest teilweisen Ausgleich und bevorzugt vollständigen Ausgleich der durch die Druckspannungen der verbleibenden Modifikationsbestandteile bewirkten Verformung beaufschlagt oder
die Metallschicht in einem Temperaturbereich oberhalb der Raumtemperatur an der Festkörperschicht (4) erzeugt wird,
wobei der Temperaturbereich mindestens 100C C oder 150°C oder 200°C oder 250°C oder 300°C oder 350°C oder 400°C über der Raumtemperatur liegt und besonders bevorzugt bis maximal 2000°C oder kleiner als die Schmelz- oder Verdampfungstemperatur des Festkörpermaterials ist,
wobei durch das Abkühlen der Metallschicht auf Raumtemperatur die Festkörperschicht zum zumindest teilweisen Ausgleich und bevorzugt vollständigen Ausgleich der durch die Druckspannungen der verbleibenden Modifikationsbestandteile bewirkten Verformung beaufschlagt.

4. Verfahren nach einem der vorangegangenen Ansprüche, wobei die Metallschicht durch Sputtern oder elektrochemisches Abscheiden erzeugt wird.

5. Verfahren nach einem der vorangegangenen Ansprüche,
wobei der Festkörper aus Siliziumcarbid, SiC, besteht oder SiC aufweist,
wobei die Festkörperschicht (4) mit einer Dicke von weniger als 200 µm, insbesondere mit einer Dicke von weniger als 150 µm oder von weniger als 125 µm oder von weniger als 110 µm oder von weniger als 100 µm oder von weniger als 90 µm oder von weniger als 75 µm, vom Festkörper (1 ) abgetrennt wird.

6. Verfahren nach Anspruch 5, wobei
eine Numerische Apertur zwischen 0,4 und 0,8, insbesondere bei 0,4, liegt,
eine Einstrahltiefe zwischen 50pm und 500pm, insbesondere bei 180pm, liegt,
ein Pulsabstand zwischen 0,1 µm und 3 µm, insbesondere bei 1 µm, liegt,
ein Linienabstand zwischen 10µm und 100µm, insbesondere bei 75 µm, liegt,
eine Pulsdauer zwischen 100 fs und 10 ns, insbesondere bei 3 ns oder zwischen 3 ns und 0,2 ns, insbesondere zwischen 2 ns und 0,5 ns oder zwischen 1,5 ns und 0,6 ns, liegt, und
eine Pulsenergie zwischen 0,5 µJ und 30 µJ, insbesondere bei 7 µJ, liegt.

7. Verfahren nach einem der Ansprüche 2 bis 6,
wobei die elektrischen Komponenten vertikale Bauelemente sind, insbesondere Schottky-Dioden (200) und/oder Metall-Oxid-Halbleiter-Feldeffekttransistor (MOSFETs) (250), und
wobei die Metallschicht einen elektrischen Kontakt, insbesondere einen ohmschen Kontakt, ausbildet und/oder eine Schnittstelle zur Wärmeabfuhr ausbildet.

8. Verfahren nach einem der Ansprüche 2 bis 6,
wobei die elektrischen Komponenten horizontale Bauelemente sind, insbesondere High-Electron-Mobility Transistors, HEMTs, sind, und
wobei die die Metallschicht bevorzugt eine Schnittstelle zur Wärmeabfuhr ausbildet.

9. Verfahren nach einem der Ansprüche 2 bis 8,
wobei im Durchschnitt pro cm² einer ebenen Oberflächenseite der Festkörperschicht eine Vielzahl, insbesondere mindestens 10 oder mindestens 50 oder mindestens 100, an elektrischen Komponenten erzeugt wird, und
wobei die elektrischen Komponenten nach ihrer Erzeugung mittels Dicing voneinander getrennt werden.

10. Verfahren nach einem der vorangegangenen Ansprüche,
wobei zum Einleiten der äußeren Kraft eine Aufnahmeschicht (140) an einer freiliegenden Oberfläche (5) der Kompositstruktur oder der abzutrennenden Festkörperschicht (4) angeordnet wird,
wobei die Aufnahmeschicht (140) ein Polymermaterial aufweist und die Aufnahmeschicht (140) zum, insbesondere mechanischen, Erzeugen von Spannungen in dem Festkörper (2) thermisch beaufschlagt wird,
wobei die thermische Beaufschlagung ein Abkühlen der Aufnahmeschicht auf eine Temperatur unterhalb der Umgebungstemperatur darstellt,
wobei die Abkühlung derart erfolgt, dass das Polymermaterial der Aufnahmeschicht (140) einen Glasübergang vollzieht und wobei sich durch die Spannungen ein Riss in dem Festkörper (2) entlang der Ablöseebene (8) ausbreitet, der die Festkörperschicht (4) von dem Festkörper (2) abtrennt.

11. Verfahren nach einem der vorangegangenen Ansprüche,
wobei der Festkörper (1) vor der Erzeugung der Ablöseebene (8) mit mindestens einem Hochtemperaturverfahren behandelt wird,
wobei das Hochtemperaturverfahren mit einer Temperatur zwischen 70°C und der Schmelztemperatur oder Verdampfungstemperatur des Materials des Festkörpers (1) ausgeführt wird,
wobei das mindestens eine Hochtemperaturverfahren ein Epitaxieverfahren, ein Dotierverfahren oder ein Verfahren unter Plasmaeinsatz ist,
wobei durch das Hochtemperaturverfahren mindestens eine Schicht (145) auf dem Festkörper (1) erzeugt wird,
wobei die mindestens eine erzeugte Schicht (145) vordefinierte Parameter aufweist, wobei zumindest ein vordefinierter Parameter einen maximalen Grad an Brechung und/oder Absorption und/oder Reflexion von Laserlichtwellen vorgibt, und
wobei der Grad an Brechung und/oder Absorption und/oder Reflexion unter 5% und bevorzugt unter 1 % und besonders bevorzugt unter 0,1% liegt.

12. Verfahren nach einem der vorangegangenen Ansprüche,
wobei die Modifikationen (9) mittels Mehrphotonenanregung erzeugt werden, wobei zunächst eine Vielzahl an Basis-Modifikationen auf einer zumindest abschnittsweise homogen verlaufenden, insbesondere gekrümmten, Linie, insbesondere in dem homogen verlaufenden Abschnitt, erzeugt werden,
wobei diese Basis-Modifikationen mit vordefinierten Prozessparametern erzeugt werden, wobei die vordefinierten Prozessparameter bevorzugt die Energie pro Schuss und/oder die Schussdichte umfassen,
wobei zumindest ein Wert dieser Prozessparameter und bevorzugt beide Werte oder alle Werte dieser Prozessparameter oder mehr als zwei Werte dieser Prozessparameter in Abhängigkeit von der Kristallgitterstabilität des Festkörpers festgelegt wird,
wobei der Wert so gewählt ist, dass das Kristallgitter um die jeweiligen Basis-Modifikationen herum intakt bleibt, wobei ferner Auslösemodifikation zum Auslösen von unterkritischen Rissen erzeugt werden,
wobei zumindest ein Prozessparameter zum Erzeugen der Auslösemodifikationen von zumindest einem Prozessparameter zum Erzeugten der Basis-Modifikationen verschieden ist, bevorzugt sind mehrere Prozessparameter voneinander verschieden, und/oder die Auslösemodifikationen in einer Richtung erzeugt werden, die zur Verlaufsrichtung der Linie, entlang der die Basis-Modifikationen erzeugt werden, geneigt oder beabstandet ist, und
wobei sich die unterkritischen Risse weniger als 5mm ausbreiten.

13. Verfahren nach Anspruch 12,
wobei sich die unterkritischen Risse zwischen 5 µm und 200 µm, insbesondere zwischen 10 µm und 100 µm oder zwischen 10 µm und 50 µm oder zwischen 10 µm und 30 µm oder zwischen 20 µm und 100 µm oder zwischen 20 µm und 50 µm oder zwischen 20 µm und 30 µm, im Festkörper ausbreiten und/oder
Abschnitte zwischen den Bereichen mehrerer Linien, in denen sich die unterkritischen Risse ausgebreitet haben, infolge der Spannungen, die durch den Glasübergang erzeugt werden, einreißen.

14. Verfahren nach einem der vorangegangenen Ansprüche,
wobei an der freiliegenden Oberfläche oder freiliegenden Schicht oder den freiliegenden Bauteilen (150) der erzeugten Kompositstruktur eine Stabilisierungsschicht (142) zum Begrenzen von Verformungen der freiliegenden Schicht oder der freiliegenden Bauteile (150) angeordnet oder erzeugt wird, wobei die Verformungen aus den mittels der Aufnahmeschicht (150) eingeleiteten mechanischen Spannungen resultieren,
wobei die Stabilisierungsschicht (142) bevorzugt ein Keramikmaterial aufweist oder aus einem Keramikmaterial besteht und/oder ein Polymermaterial aufweist oder aus einem Polymermaterial besteht, die Stabilisierungsschicht (142) bevorzugt in-situ erzeugt wird oder als Folie bereitgestellt wird und/oder die Stabilisierungsschicht (142) die Schicht oder die freiliegenden Bauteile (150) bevorzugt eingießt und/oder die Stabilisierungsschicht (142) bevorzugt durch Aufbringen eines Lösungsmittels oder durch Eintauchen in ein Lösungsmittel von der Schicht entfernt wird oder von den Bauteilen (150) entfernt wird.

15. Mehrkomponenten-Anordnung, die mindestens eine Festkörperschicht aufweist,
wobei die Festkörperschicht zu mehr als 50% (massemäßig), insbesondere zu mehr als 75% (massemäßig) oder zu mehr als 90% (massemäßig) oder zu mehr als 95% (massemäßig) oder zu mehr als 98% (massemäßig) oder zu mehr als 99% (massemäßig) aus SiC besteht,
wobei die Festkörperschicht im Bereich einer ersten Oberfläche Druckspannungen erzeugende Modifikationen oder Modifikationsbestandteile aufweist,
wobei die Modifikationen amorphisierte Bestandteile der Festkörperschicht sind,
wobei die Modifikationen näher zur ersten Oberfläche beabstandet sind oder diese mit ausbilden als zu einer zweiten Oberfläche,
wobei die zweite Oberfläche parallel oder im Wesentlichen parallel zur ersten Oberfläche ausgebildet ist,
wobei die erste Oberfläche eben oder im Wesentlichen eben ist, **dadurch gekennzeichnet, dass**
die Mehrkomponenten-Anordnung weiter mindestens eine Metallschicht aufweist,
wobei die Metallschicht an der ersten Oberfläche der Festkörperschicht erzeugt ist, und
wobei die erste Oberfläche durch Ablösen der Festkörperschicht von einem Festkörper gebildet ist.

## Claims

1. Method for providing at least one solid-state layer (4), wherein the solid-state layer (4) is separated from a solid body (1) and wherein the method at least comprises:
generating a plurality of modifications (9) by means of laser beams inside the solid body (1) in order to form a separation plane (8), wherein compressive stresses are generated in the solid body (1) by the modifications (9),
separating the solid-state layer (4) by a separation of the remaining solid body (1) and the solid-state layer (4) along the separation plane (8) formed by the modifications (9), wherein at least portions of the modifications (9) generating the compressive stresses remain on the solid-state layer (4),
wherein so many modifications (9) are generated that the solid-state layer (4) separates from the solid body (1) due to the modifications (9) or
wherein an external force is introduced into the solid body (1) in order to generate further stresses in the solid body (1), wherein the external force is so strong that the stresses cause a crack propagation along the separation plane (8) formed by the modifications,
wherein the method is **characterized by**
generating a metal layer (20) on the surface exposed by the separation of the solid-state layer (4) from the solid body (1) for at least partially and preferably predominantly and particularly preferably completely compensating a deformation of the solid-state layer (4) caused by the compressive stresses of the remaining modification portions, or for at least partially and preferably predominantly or completely compensating the compressive stresses.

2. Method according to claim 1, for generating electrical components, wherein the method further comprises:
generating a composite structure by arranging or generating layers and/or components (150) on or above an initially exposed surface (5) of the solid body (1), wherein the exposed surface (5) is a portion of the solid-state layer (4) to be separated.

3. Method according to claim 1 or 2,
wherein the metal layer is generated on the solid-state layer (4) in a first aggregate state and a temperature above room temperature and is present in a second aggregate state at room temperature,
wherein, due to the transition from the first aggregate state to the second aggregate state, the metal layer acts on the solid-state layer in order to at least partially compensate and preferably completely compensate the deformation caused by the compressive stresses of the remaining modification portions, or
the metal layer is generated on the solid-state layer (4) in a temperature range above room temperature,
wherein the temperature range is at least 100°C or 150°C or 200°C or 250°C or 300°C or 350°C or 400°C above room temperature and particularly preferably up to a maximum of 2000°C or less than the melting or evaporation temperature of the solid-state material,
wherein, due to the cooling of the metal layer to room temperature, the solid-state layer acts on the solid-state layer in order to at least partially compensate and preferably completely compensate the deformation caused by the compressive stresses of the remaining modification portions.

4. Method according to one of the preceding claims, wherein the metal layer is generated by sputtering or electrochemical deposition.

5. Method according to one of the preceding claims,
wherein the solid body consists of silicon carbide, SiC, or comprises SiC,
wherein the solid-state layer (4) is separated from the solid body (1) with a thickness of less than 200 µm, in particular with a thickness of less than 150 µm or of less than 125 µm or of less than 110 µm or of less than 100 µm or of less than 90 µm or of less than 75 µm.

6. Method according to claim 5, wherein
a numerical aperture is between 0.4 and 0.8, in particular at 0.4,
an irradiation depth is between 50 µm and 500 µm, in particular at 180 µm,
a pulse spacing is between 0.1 µm and 3 µm, in particular at 1 µm,
a line spacing is between 10 µm and 100 µm, in particular at 75 µm,
a pulse duration is between 100 fs and 10 ns, in particular at 3 ns or between 3 ns and 0.2 ns, in particular between 2 ns and 0.5 ns or between 1.5 ns and 0.6 ns, and
a pulse energy is between 0.5 µJ and 30 µJ, in particular at 7 µJ.

7. Method according to one of claims 2 to 6,
wherein the electrical components are vertical components, in particular Schottky diodes (200) and/or metal oxide semiconductor field effect transistors (MOSFETs) (250), and
wherein the metal layer forms an electrical contact, in particular an ohmic contact, and/or forms an interface for heat dissipation.

8. Method according to one of claims 2 to 6,
wherein the electrical components are lateral components, in particular high electron mobility transistors, HEMTs, and
wherein the metal layer preferably forms an interface for heat dissipation.

9. Method according to one of claims 2 to 8,
wherein a plurality, in particular at least 10 or at least 50 or at least 100, of electrical components is generated on average per cm² of a planar surface side of the solid-state layer, and
wherein the electrical components are separated from one another by means of dicing after their generation.

10. Method according to one of the preceding claims,
wherein a receiving layer (140) is arranged on an exposed surface (5) of the composite structure or of the solid-state layer (4) to be separated in order to introduce the external force,
wherein the receiving layer (140) comprises a polymer material and the receiving layer (140) is acted on thermally in order to generate, in particular mechanically, stresses in the solid body (2),
wherein the thermal application represents a cooling of the receiving layer to a temperature below the ambient temperature,
wherein the cooling takes place in such a way that the polymer material of the receiving layer (140) undergoes a glass transition and wherein a crack propagates in the solid body (2) along the separation plane (8) as a result of the stresses, which crack separates the solid-state layer (4) from the solid body (2).

11. Method according to one of the preceding claims,
wherein the solid body (1) is treated with at least one high-temperature method before the generation of the separation plane (8),
wherein the high-temperature method is carried out with a temperature between 70°C and the melting temperature or evaporation temperature of the material of the solid body (1),
wherein the at least one high-temperature method is an epitaxy method, a doping method or a method using plasma,
wherein at least one layer (145) is generated on the solid body (1) by the high-temperature method,
wherein the at least one generated layer (145) has predefined parameters, wherein at least one predefined parameter specifies a maximum degree of refraction and/or absorption and/or reflection of laser light waves, and
wherein the degree of refraction and/or absorption and/or reflection is below 5% and preferably below 1% and particularly preferably below 0.1%.

12. Method according to one of the preceding claims,
wherein the modifications (9) are generated by means of multi-photon excitation, wherein firstly a plurality of base modifications are generated on a line, in particular a curved line, which runs homogeneously at least in sections, in particular in the homogeneously running section,
wherein these base modifications are generated with predefined process parameters, wherein the predefined process parameters preferably comprise the energy per shot and/or the shot density,
wherein at least one value of these process parameters and preferably both values or all values of these process parameters or more than two values of these process parameters is/are fixed depending on the crystal lattice stability of the solid body,
wherein the value is selected such that the crystal lattice remains intact around the respective base modifications, wherein furthermore triggering modifications for triggering subcritical cracks are generated,
wherein at least one process parameter for generating the triggering modifications is different from at least one process parameter for generating the base modifications, preferably a plurality of process parameters are different from one another, and/or the triggering modifications are generated in a direction which is inclined or spaced apart from the running direction of the line along which the base modifications are generated, and
wherein the subcritical cracks propagate less than 5 mm.

13. Method according to claim 12,
wherein the subcritical cracks propagate in the solid body between 5 µm and 200 µm, in particular between 10 µm and 100 µm or between 10 µm and 50 µm or between 10 µm and 30 µm or between 20 µm and 100 µm or between 20 µm and 50 µm or between 20 µm and 30 µm, and/or
sections between the regions of a plurality of lines in which the subcritical cracks have propagated tear in as a result of the stresses which are generated by the glass transition.

14. Method according to one of the preceding claims,
wherein a stabilizing layer (142) for limiting deformations of the exposed layer or of the exposed components (150) is arranged or generated on the exposed surface or the exposed layer or the exposed components (150) of the generated composite structure, wherein the deformations result from the mechanical stresses introduced by means of the receiving layer (150),
wherein the stabilizing layer (142) preferably comprises a ceramic material or consists of a ceramic material and/or comprises a polymer material or consists of a polymer material, the stabilizing layer (142) is preferably generated in-situ or is provided as a film and/or the stabilizing layer (142) preferably casts in the layer or the exposed components (150) and/or the stabilizing layer (142) is preferably removed from the layer or removed from the components (150) by application of a solvent or by immersion in a solvent.

15. Multi-component arrangement which comprises at least one solid-state layer,
wherein the solid-state layer consists of SiC to an extent of more than 50% (by mass), in particular to an extent of more than 75% (by mass) or to an extent of more than 90% (by mass) or to an extent of more than 95% (by mass) or to an extent of more than 98% (by mass) or to an extent of more than 99% (by mass),
wherein the solid-state layer comprises modifications or modification portions which generate compressive stresses in the region of a first surface,
wherein the modifications are amorphized portions of the solid-state layer,
wherein the modifications are spaced apart closer to the first surface, or also form the latter, than to a second surface,
wherein the second surface is formed parallel or substantially parallel to the first surface,
wherein the first surface is planar or substantially planar,
**characterized in that**
the multi-component arrangement further comprises a metal layer,
wherein the metal layer is generated on the first surface of the solid-state layer, and
wherein the first surface is formed by separating the solid-state layer from a solid body.

## Revendications

1. Procédé pour disposer d'au moins une couche (4) de corps solide, dans lequel on sépare la couche (4) de corps solide d'un corps (1) solide et dans lequel le procédé comprend au moins :
production d'une pluralité de modifications (9) au moyen de rayons laser au sein du corps (1) solide pour la constitution d'un plan (8) de détachement, dans lequel, par les modifications (9), on produit des contraintes de compression dans le corps (1) solide,
séparation de la couche (4) de corps solide en séparant la couche (4) de corps solide du corps (1) solide restant le long du plan (8) de détachement constitué par les modifications (9), dans lequel au moins des parties constitutives des modifications (9) produisant les contraintes de compression restent sur la couche (4) de corps solide,
dans lequel on produit tant de modifications (9) que la couche (4) de corps solide se détache du corps (1) solide en raison des modifications (9), ou
dans lequel on applique une force extérieure au corps (1) solide pour la production d'autres contraintes dans le corps (1) solide, dans lequel la force extérieure est si intense que les contraintes provoquent une propagation de fissure le long du plan (8) de détachement formé par les modifications,
le procédé étant **caractérisé par**
production d'une couche (20) métallique à la surface mise à nu en séparant la couche (4) du corps solide du corps (1) solide pour la compensation au moins partielle, et de préférence pour la plus grande partie, et d'une manière particulièrement préférée complète, d'une déformation de la couche (4) de corps solide provoquée par les contraintes de compression des parties constitutives restantes de modifications ou pour la compensation au moins partielle, et de préférence pour la plus grande partie ou complète, des contraintes de compression.

2. Procédé suivant la revendication 1 de production de composants électriques, dans lequel le procédé comprend en outre :
production d'une structure composite par mise en place ou production de couches et/ou de composants (150) sur ou au-dessus d'une surface (5), d'abord mise à nu, du corps (1) solide, dans lequel la surface (5) mise à nu est une partie constitutive de la couche (4) de corps solide à séparer.

3. Procédé suivant la revendication 1 ou 2,
dans lequel on produit la couche métallique dans un premier état d'agrégat et à une température au-dessus de la température ambiante sur la couche (4) de corps solide et elle est à la température ambiante dans un deuxième état d'agrégat,
dans lequel, par le passage du premier état d'agrégat au deuxième état d'agrégat, la couche métallique sollicite la couche de corps solide pour la compensation au moins partielle, et de préférence pour la compensation complète, de la déformation provoquée par les contraintes de compression des parties constitutives restantes des modifications, ou
on produit la couche métallique dans une plage de températures au-dessus de la température ambiante sur la couche (4) de corps solide,
dans lequel la plage de températures est de 100°C ou 150°C ou 200°C ou 250°C ou 300°C ou 350°C ou 400°C au-dessus de la température ambiante, et d'une manière particulièrement préférée, jusqu'à un maximum de 2000°C ou plus basse que le point de fusion ou d'évaporation du matériau du corps solide,
dans lequel, par refroidissement de la couche métallique à la température ambiante, on sollicite la couche de corps solide pour la compensation au moins partielle, de préférence pour la compensation complète de la déformation provoquée par les contraintes de compression des parties constitutives restantes des modifications.

4. Procédé suivant l'une des revendications précédentes, dans lequel on produit la couche métallique par pulvérisation cathodique ou par dépôt électrochimique.

5. Procédé suivant l'une des revendications précédentes,
dans lequel le corps solide est en carbure de sillicium, SiC, ou comporte du SiC,
dans lequel on sépare du corps (1) solide la couche (4) de corps solide en une épaisseur de moins de 200 µm, en particulier en une épaisseur de moins de 150 µm ou de moins de 125 µm ou de moins de 110 µm ou de moins de 100 µm ou de moins de 90 µm ou de moins de 75 µm.

6. Procédé suivant la revendication 5,
l'ouverture numérique est comprise entre 0,4 et 0,8 , en étant en particulier de 0,4,
la profondeur de pénétration est comprise entre 50 pm et 500 pm ,en étant en particulier de 180 pm,
la distance entre les impulsions est comprise entre 0,1 µm et 3 nµm, en étant en particulier de 1 µm,
la distance linéaire est comprise entre 10 µm et 100 µm en étant en particulier de 75 µm,
la durée des impulsions est comprise entre 100 fs et 10 ns, en étant en particulier de 3 ns ou est comprise entre 3 ns et 0,2 ns, en étant en particulier comprise entre 2 ns et 0,5 ns ou entre 1,5 ns et 0,6 ns, et
l'énergie des impulsions est comprise entre 0,5 µJ et 30 µJ, en étant en particulier de 7 µJ.

7. Procédé suivant l'une des revendications 2 à 6,
dans lequel les composants électriques sont des composants verticaux, en étant en particulier des diodes (200) de Schottky et/ou des transistors à effet champ métal oxyde semiconducteur (MOSFETs) (250), et
dans lequel la couche métallique forme un contact électrique, en particulier un contact ohmique et/ou une interface pour la dissipation de la chaleur.

8. Procédé suivant l'une des revendications 2 à 6,
dans lequel les composants électriques sont des composants horizontaux, en étant en particulier des transistors à grande mobilité des électrons, HEMTs, et
dans lequel la couche métallique forme, de préférence une interface de dissipation de la chaleur.

9. Procédé suivant l'une des revendications 2 à 8,
dans lequel, en moyenne par cm² d'un côté plan de surface de la couche de corps solide, on produit une pluralité, en particulier au moins 10 ou au moins 50 ou au moins 100, composants électriques, et
dans lequel on sépare les uns des autres, au moyen d'un dicing, les composants électriques après leur production.

10. Procédé suivant l'une des revendications précédentes,
dans lequel, pour appliquer la force extérieure, on met une couche (140) de réception sur une surface (5) à nu de la structure composite ou de la couche (4) de corps solide à séparer,
dans lequel la couche (140) de réception comporte une matière polymère et on sollicite thermiquement la couche (140) de réception pour la production, en particulier mécanique, de contraintes dans le corps (2) solide,
dans lequel la sollicitation thermique représente un refroidissement de la couche de réception et une température inférieure à la température ambiante,
dans lequel le refroidissement s'effectue de manière à ce que la matière polymère de la couche (140) de réception subisse une transition à l'état vitreux et dans lequel, par les contraintes, une fissure se propage dans le corps (2) solide le long du plan (8) de détachement, qui sépare la couche (4) de corps solide du corps (2) solide.

11. Procédé suivant l'une des revendications précédentes,
on traite le corps (1) solide avant la production du plan (8) de détachement par au moins un procédé à haute température,
dans lequel on effectue le procédé à haute température à une température comprise entre 70°C et le point de fusion ou le point d'évaporation de la matière du corps (1) solide,
dans lequel le au moins un procédé à haute température est un procédé par épitaxie, un procédé de dopage ou un procédé avec utilisation de plasma,
dans lequel on produit au moins une couche (145) sur le corps (1) solide par le procédé à haute température,
dans lequel la au moins une couche (145) produite a des paramètres définis à l'avance, dans lequel au moins un paramètre défini à l'avance prescrit un degré maximum de réfraction et/ou d'absorption et/ou de réception d'ondes lumineuses laser, et
dans lequel le degré de réfraction et/ou d'absorption et/ou de réflexion est inférieur à 5 %, et de préférence inférieur à 1 %, et d'une manière particulièrement préférée inférieure à 0,1 %.

12. Procédé suivant l'une des revendications précédentes,
dans lequel on produit les modifications (9) au moyen d'une excitation par plusieurs photons, dans lequel on produit d'abord une pluralité de modifications de base sur une ligne notamment incurvée s'étendant de manière homogène au moins par tronçon, en particulier dans le tronçon s'étendant de manière homogène,
dans lequel on produit ces modifications de base par des paramètres de processus définis à l'avance, des processus de paramètres définis à l'avance comprenant, de préférence l'énergie par coup et/ou la densité de coup,
dans lequel on fixe au moins une valeur de ce paramètre de processus, de préférence les deux valeurs ou toutes les valeurs de ces paramètres de processus ou plus de deux valeurs de ces paramètres de processus, en fonction de la stabilité du réseau cristallin du corps solide, dans lequel on choisit la valeur de manière à ce que le réseau cristallin reste intact tout autour des modifications de base respectives, dans lequel on produit en outre des modifications de détachement pour le détachement de fissures sous-critiques,
dans lequel au moins un paramètre de processus pour la production des modifications de détachement est différent d'au moins un processus pour la production des modifications de base, de préférence plusieurs paramètres de processus sont différents les uns des autres et/ou on produit les modifications de détachement dans une direction, qui, par rapport à la direction de la ligne le long de laquelle on produit les modifications de base, est inclinée ou elles en sont à distance, et
dans lequel les fissures sous-critiques se propagent sur moins de 5 mm.

13. Procédé suivant la revendication 12,
dans lequel les fissures sous-critiques se propagent dans le corps entre 5 µm et 200 µm, en particulier entre 10 µm et 100 µm ou entre 10 µm et 50 µm ou entre 10 µm et 30 µm ou entre 20 µm et 100 µm ou entre 20 µm et 50 µm ou entre 20 µm et 30 µm, et/ou
des tronçons entre les parties de plusieurs lignes, dans lesquelles les fissures sous-critiques se sont propagées, se déchirent en fonction des contraintes, qui sont produites par la transition à l'état vitreux.

14. Procédé suivant l'une des revendications précédentes,
dans lequel, sur la surface à nu ou la couche à nu ou les composants (150) à nu de la structure composite produite, on met ou on produit une couche (142) de stabilisation pour la limitation de déformations de la couche à nu ou des composants (150) à nu, dans lequel les déformations résultent de contraintes mécaniques appliquées au moyen de la couche (150) de réception,
dans lequel la couche (142) de stabilisation comporte, de préférence un matériau céramique ou est constituée d'un matériau céramique et/ou comporte une matière polymère ou est constituée d'une matière polymère, la couche (142) de stabilisation étant produite, de préférence in situ ou sous la forme d'une feuille et/ou la couche (142) de stabilisation prend en coulée de préférence la couche ou les composants (150) à nu et/ou on élimine, de la couche ou des composants (150), la couche (142) de stabilisation, de préférence par dépôt d'un solvant ou par immersion dans un solvant.

15. Agencement de composants multiples, qui a au moins une couche de corps solide,
dans lequel la couche de corps solide est constituée pour plus de 50 % (en masse), en particulier pour plus de 75 % (en masse) ou plus de 90 % (en masse) ou pour plus de 95 % (en masse) ou pour plus de 98 % (en masse) ou pour plus de 99 % (en masse) de SiC,
dans lequel la couche de corps solide a, dans la partie d'une première surface, des modifications ou des parties constitutives de modifications produisant des contraintes de compression,
dans lequel les modifications sont des parties constitutives rendues amorphes de la couche de corps solide,
dans lequel les modifications sont plus proches de la première surface ou sont constituées avec celle-ci que d'une deuxième surface,
dans lequel la deuxième surface est constituée parallèlement ou sensiblement parallèlement à la première surface,
dans lequel la première surface est plane ou sensiblement plane,
**caractérisé en ce que**
l'agencement de composants multiples comporte une couche métallique,
dans lequel la couche métallique est produite sur la première surface de la couche de corps solide,
dans lequel la première surface est formée par détachement d'une couche de corps solide d'un corps solide.
